# EUROPÄISCHE PATENTSCHRIFT

(11) **EP 1 099 139 B1**
(45) Veröffentlichungstag und Bekanntmachung des Hinweises auf die Patenterteilung: **03.02.2010**
(21) Anmeldenummer: 99973863.6
(22) Anmeldetag: 19.05.1999
(51) Int. Cl.: G03F 7/20

(54) **Lithographieverfahren**
Lithography method
Procédé de lithographie

(43) Veröffentlichungstag der Anmeldung: 16.05.2001
(73) Patentinhaber: Deutsches Zentrum für Luft- und Raumfahrt e.V., 51147 Köln (DE)
(72) Erfinder: BRAUCH, Uwe, 70565 Stuttgart (DE); OPOWER, Hans, 82152 Krailling (DE)
(74) Vertreter: Beck, Jürgen
(86) Internationale Anmeldenummer: PCT/EP1999/003432
(87) Internationale Veröffentlichungsnummer: WO 2000/072092

(56) Entgegenhaltungen:
- WO-A-98/00760
- DE-A- 3 118 802
- DE-A- 19 522 936

## Beschreibung

Die Erfindung betrifft ein Lithographieverfahren zum Herstellen von sich in einer Fläche erstreckenden Strukturen in einer lichtempfindlichen Schicht mit einer Aufnahme für die lichtempfindliche Schicht, mit einer Belichtungseinheit umfassend mindestens eine Laserstrahlungsquelle, eine der Laserstrahlungsquelle zugeordnete Fokussierungsoptik für die Laserstrahlung und eine der Fokussierungsoptik zugeordnete Blende umfassend eine in einer Längsrichtung langgestreckte Blendenöffnung, mit welcher ein Strahlungsfeld in der lichtempfindlichen Schicht erzeugbar ist, welches in einer quer zur Längsrichtung der Blendenöffnung verlaufenden Breitenrichtung eine wirksame Breitenausdehnung aufweist, die in der Größenordnung der Wellenlänge der Laserstrahlung oder kleiner ist, mit einer Bewegungseinheit zur Erzeugung einer Relativbewegung zwischen der Fokussierungsoptik und der Aufnahme und mit einer Steuerung zur Steuerung der Intensität und Lage des Strahlungsfeldes relativ zur lichtempfindlichen Schicht derart, daß mittels einer großen Zahl aufeinanderfolgender Belichtungsschritte eine Vielzahl von Umwandlungsbereichen in der lichtempfindlichen Schicht erzeugbar ist, in denen das Material der lichtempfindlichen Schicht von einem Ausgangszustand in einen umgewandelten Endzustand umgewandelt ist und die zusammen die Strukturen ergeben.

Ein derartiges Lithographieverfahren ist aus der WO 98/00760 bekannt. Dieses Lithographieverfahren ist allerdings nur dazu vorgesehen, Strukturen darzustellen, deren Ausdehnung größer als die des Strahlungsfeldes ist.

Der Erfindung liegt nunmehr die Aufgabe zugrunde, ein Lithographie verfahren zu schaffen, bei welchem die Möglichkeit besteht, Strukturen maskenfrei herzustellen, die in mindestens einer Richtung eine Erstreckung aufweisen, die kleiner ist als die eines der eingesetzten Strahlungsfelder.

Insbesondere ist die Aufgabe der vorliegenden Erfindung, ein Lithographieverfahren zu schaffen, bei welchem Strukturen im Bereich kleiner 200 Nanometer Ausdehnung herstellbar sind.

Diese Aufgabe wird durch ein Lithographieverfahren der eingangs beschriebenen Art erfindungsgemäß dadurch gelöst, daß die Steuerung bei mindestens einem Teil der Belichtungsschritte Strahlungsfelder mit einer Energieverteilung erzeugt, welche die Einwirkung mindestens zweier Strahlungsfelder auf denselben Umwandlungsbereich erforderlich macht, um in diesem das Material der lichtempfindlichen Schicht in den umgewandelten Endzustand zu überführen.

Der Kern der erfindungsgemäßen Lösung ist somit darin zu sehen, daß die Intensität und die Intensitätsverteilung der eingesetzten Strahlungsfelder so abgestimmt ist, daß die Einwirkung eines Strahlungsfeldes in dem Einwirkungsbereich der lichtempfindlichen Schicht nicht zu einer Überführung des Materials von dem Ausgangszustand in den umgewandelten Endzustand führt, sondern lediglich zu einer Teilumwandlung, die noch nicht den gewünschten Zustand aufweist. Erst die Einwirkung mindestens eines zweiten Strahlungsfeldes auf denselben Umwandlungsbereich, schafft die Möglichkeit, daß in dem Bereich, in dem sich die beiden Strahlungsfelder überlappen, die Möglichkeit einer vollständigen Umwandlung des Materials der lichtempfindlichen Schicht in den umgewandelten Zustand besteht, sofern die Intensitätsverteilungen so sind, daß die Summe der Intensitäten in dem Umwandlungsbereich ausreichend groß ist, um die Schwellintensität für die Umwandlung des lichtempfindlichen Materials von dem Ausgangszustand in den umgewandelten Zustand zu überschreiten.

Damit besteht die Möglichkeit, durch den Einsatz und die Einwirkung zweier Strahlungsfelder und die Tatsache, daß sich die Wirkungen der Intensitäten addieren müssen, um die Schwelle für die Umwandlung des Materials der lichtempfindlichen Schicht zu überschreiten, die Möglichkeit, mindestens Teilbereiche von Strukturen herzustellen, in denen die Ausdehnung der Teilbereiche in einer Richtung maximal gleich groß, wenn nicht kleiner ist als die Ausdehnung eines der Strahlungsfelder in der jeweiligen Richtung.

Prinzipiell besteht die Möglichkeit, jedem Strahlungsfeld eine derartige Intensitätsverteilung zu verleihen, daß selbst bei deckungsgleicher Überlagerung mindestens zweier Strahlungsfelder lediglich in einem Teilbereich der Strahlungsfelder die Schwelle für die Umwandlung des Materials der lichtempfindlichen Schicht von dem Ausgangszustand in den umgewandelten Zustand überschritten wird, so daß bereits die deckungsgleiche Überlagerung zweier Strahlungsfelder letztlich zu einem Umwandlungsbereich führt, der in mindestens einer Richtung eine Erstreckung aufweist, die kleiner ist als die der beiden eingesetzten Strahlungsfelder selbst.

Eine besonders günstige Lösung sieht jedoch vor, daß die beiden auf denselben Umwandlungsbereich einwirkenden Strahlungsfelder nicht deckungsgleich sondern nur teilweise überlappend angeordnet sind, so daß bereits durch die teilweise Überlappung der Strahlungsfelder ein maximal dem Überlappungsbereich entsprechender Umwandlungsbereich erzeugbar ist, der in Richtung der teilweisen Überlappung eine Ausdehnung aufweist, die kleiner ist als die von einem der Strahlungsfelder selbst.

Bei der überlappenden Anordnung zweier Strahlungsfelder besteht die Möglichkeit, die Strahlungsfelder in paralleler Ausrichtung zueinander, das heißt mit parallel zueinander verlaufenden Längsrichtungen, anzuordnen und zwar so, daß sich diese teilweise überlappen.

Eine besonders vorteilhafte Lösung sieht vor, daß zur Erzeugung eines Umwandlungsbereichs ein erstes, in einer ersten Richtung ausgerichtetes Strahlungsfeld mit einem zweiten, in einer zweiten, schräg oder quer zur ersten Richtung verlaufenden Strahlungsfeld überlappend angeordnet ist, so daß durch die schräg oder quer zueinander verlaufenden Strahlungsfelder bereits von vornherein eine vollständige Überlappung ausgeschlossen ist und nur noch eine teilweise Überlappung möglich ist, und somit der Umwandlungsbereich maximal eine Ausdehnung aufweisen kann, die dem Überlappungsbereich der beiden Strahlungsfelder entspricht.

Besonders vorteilhaft ist es dabei, wenn das zweite Strahlungsfeld relativ zu dem ersten Strahlungsfeld im wesentlichen in einem rechten Winkel verläuft.

Eine weitere vorteilhafte Ausführungsform sieht vor, daß mehr als zwei Strahlungsfelder teilweise miteinander überlappend eingesetzt werden, um einen Umwandlungsbereich in der lichtempfindlichen Schicht zu erhalten.

In einem derartigen Fall ist vorzugsweise vorgesehen, daß die zu einem einzigen Umwandlungsbereich beitragenden Strahlungsfelder ungefähr in gleichem Winkelabstand aufeinanderfolgend angeordnet sind.

Hinsichtlich der teilweisen Überlagerung schräg oder quer zueinander ausgerichteter Strahlungsfelder besteht die Möglichkeit, die langgestreckten Strahlungsfelder jeweils mit in der Längsrichtung liegenden Endbereichen miteinander zu überlagern.

Besonders vorteilhaft ist es jedoch, wenn die langgestreckten Strahlungsfelder so angeordnet sind, daß mindestens eines der Strahlungsfelder in einem mittigen Bereich mit dem anderen Strahlungsfeld überlappend angeordnet ist, um einen einzigen Umwandlungsbereich zu erzeugen.

Noch vorteilhafter ist es, wenn die Strahlungsfelder so angeordnet sind, daß deren mittige Bereiche einander teilweise überlappen.

Eine derartige Anordnung der Strahlungsfelder hat den Vorteil, daß damit die Positioniergenauigkeit der beiden Strahlungsfelder relativ zueinander geringer sein kann und daß außerdem üblicherweise in den mittigen Bereichen der Strahlungsfelder die meiste Intensität zur Verfügung steht, so daß die Überlagerung mit mittigen Bereichen der Strahlungsfelder auch summarisch zu den höchsten erhältlichen Intensitätswerten führt und damit beispielsweise auch die Intensität der Laserstrahlung optimal ausgenützt werden kann.

Hinsichtlich des zeitlichen Ablaufs, in dem die mindestens zwei Strahlungsfelder miteinander überlagert werden sind die unterschiedlichsten Lösungen denkbar.

So sieht eine Möglichkeit vor, daß die Steuerung die Laserstrahlungsquellen so steuert, daß die auf einen Umwandlungsbereich wirkenden Strahlungsfelder zeitlich nacheinander auf diesen einwirken.

In einem derartigen Fall ist das Material der lichtempfindlichen Schicht so auszubilden, daß das erste Strahlungsfeld zu einer teilweisen Umwandlung des Materials ausgehend vom Ausgangszustand führt, und diese teilweise Umwandlung so lange erhalten bleibt, bis das zweite Strahlungsfeld einwirkt und zur vollständigen Umwandlung in den umgewandelten Zustand führt.

Eine andere vorteilhafte Lösung sieht vor, daß die Strahlungsfelder mindestens zeitlich überlappend auf den Umwandlungsbereich einwirken. In diesem Fall ist es ausreichend, wenn das Material der lichtempfindlichen Schicht den durch die Einwirkung des zuerst kommenden Strahlungsfeldes erreichten Zustand so lange gespeichert hält, bis das zweite Strahlungsfeld auf das Material einwirkt.

Bei einem weiteren vorteilhaften Fall der erfindungsgemäßen Lösung ist vorgesehen, daß die Steuerung die Laserstrahlungsquellen so steuert, daß die auf einen Umwandlungsbereich einwirkenden Strahlungsfelder gleichzeitig auf diesen einwirken, wobei in diesem Fall das Material der lichtempfindlichen Schicht hinsichtlich der Intensität die Wirkung der Summe der beiden Intensitäten erfährt, so daß das Material nicht so ausgebildet sein muß, daß es eine teilweise Umwandlung zeitlich speichert.

Hinsichtlich der Ausbildung der Blende wurde bislang davon ausgegangen, daß diese lediglich eine langgestreckte Blendenöffnung aufweist. Dies heißt, daß jeder Blendenöffnung eine hinsichtlich der Intensität steuerbare Laserstrahlungsquelle zuzuordnen ist, wobei in diesem Fall unter den Begriff Laserstrahlungsquelle auch eine zur Intensitätssteuerung geeignete Einheit fällt, die mit einer Laserstrahlung konstanter Leistung versorgt wird, wobei die Laserstrahlung konstanter Leistung mehrerer derartiger intensitätssteuernder Einheiten zur Verfügung gestellt werden kann.

Damit muß jeder Blendenöffnung mindestens eine eigene Intensitätssteuerung zugeordnet werden, um dann, wenn die Blendenöffnung über dem gewünschten Umwandlungsbereich in der gewünschten Positionierung steht, die Belichtung durchzuführen.

Besonders vorteilhaft ist es jedoch, wenn die Blende zwei schräg oder quer zueinander verlaufende und überlappend angeordnete Blendenöffnungen aufweist und der Blende Laserstrahlung in zwei Polarisationsrichtungen zugeführt wird, nämlich eine Polarisationsrichtung, bei welcher das erste Strahlungsfeld entsteht und eine Polarisationsrichtung, bei welcher ein zweites schräg oder quer zum ersten Strahlungsfeld verlaufendes Strahlungsfeld entsteht.

Vorzugsweise verlaufen die Polarisationsrichtungen und die Blendenöffnungen quer, vorzugsweise ungefähr senkrecht zueinander, um eine Wechselwirkung der polarisierten Laserstrahlungen zu vermeiden.

In diesem Fall ist nur eine einzige Intensitätssteuerung für beide Strahlungsfelder erforderlich, da der Überlappungsbereich bereits durch die Anordnung der Blendenöffnungen in derselben Blende festliegt und somit ein bereits durch die Geometrie der Blendenöffnungen definierter Überlappungsbereich der Strahlungsfelder besteht, so daß jeglicher Positionieraufwand für die Anordnung des zweiten Strahlungsfeldes relativ zum ersten Strahlungsfeld und somit der Positionieraufwand für eine ausreichend präzise Überlappung, entfällt.

Selbst wenn zur Erzeugung eines Umwandlungsbereichs eine Überlappung von mehr als zwei Strahlungsfeldern erfolgt, ist vorzugsweise vorgesehen, daß diese durch zwei Blenden mit jeweils zwei einander überlappend kreuzenden Blendenöffnungen erzeugt werden.

Im Zusammenhang mit der bislang beschriebenen Ausführungsform eines erfindungsgemäßen Lithographie verfahrens wurde lediglich davon ausgegangen, daß mit diesem die mindestens zwei zur Erzeugung eines Umwandlungsbereichs miteinander überlappenden Strahlungsfelder erzeugbar sind.

Um jedoch ausreichend komplexe Strukturen in einer vertretbar kurzen Zeit herstellen zu können, ist vorzugsweise vorgesehen, daß die Lithographie-Belichtungseinrichtung eine Vielzahl von Laserstrahlungsquellen zur Erzeugung einer Vielzahl von Laserstrahlungen aufweist, mit welchen eine Vielzahl von Strahlungsfeldern erzeugbar ist, die durch die Steuerung entsprechend der Form der Struktur aktivierbar und deaktivierbar sind. Damit lassen sich vorzugsweise im Rahmen einer einzigen Belichtungsbewegung, vorzugsweise sogar in einer einzigen Belichtungsbewegungsrichtung im gleichen Zeitraum mehrere Teilbereich der Struktur herstellen.

Vorzugsweise ist dabei vorgesehen, daß die Vielzahl von erzeugbaren Strahlungsfeldern ein erstes Strahlungsfeldmuster aus definiert relativ zueinander angeordneten ersten erzeugbaren Strahlungsfeldern aufweist, deren Breitenausdehnungen parallel zu einer ersten Richtung verlaufen.

Dabei kann die erste Richtung entweder parallel zur Belichtungsbewegungsrichtung oder quer zu der Belichtungsbewegungsrichtung ausgerichtet sein.

Vorzugsweise ist die erste Richtung quer zu der Belichtungsbewegungsrichtung ausgerichtet.

Eine vorteilhafte Weiterbildung dieser Ausführungsform sieht vor, daß das erste Strahlungsfeldmuster von einem als Referenz dienendem ersten Strahlungsfeld ausgehend in einer senkrecht zur Belichtungsbewegungsrichtung verlaufenden Querrichtung in unterschiedlichen Abständen angeordnete erste Strahlungsfelder aufweist, daß jedes erste Strahlungsfeld des ersten Strahlungsfeldmusters in der Querrichtung einen anderen Abstand von dem als Referenz dienenden ersten Strahlungsfeld aufweist als die übrigen ersten Strahlungsfelder, daß die Abstände aller ersten Strahlungsfelder des ersten Strahlungsfeldmusters eine Serie von Abständen bilden, bei der jeder Abstand um ein Inkrement größer als ein anderer der Abstände ist und daß das Inkrement kleiner als eine Erstreckung der ersten Strahlungsfelder in der Querrichtung ist.

Diese Lösung hat den Vorteil, daß durch die Steuerung für die Herstellung mindestens eines Teils der Struktur lediglich eine Bewegung der Fokussierungsoptik relativ zur lichtempfindlichen Schicht in Richtung der Belichtungsbewegungsrichtung steuerbar ist und sämtliche Positionierungen der Strahlungsfelder relativ zueinander zum Erzeugen der Struktur durch Aktivierung der die einzelnen Strahlungsfelder erzeugenden Lasereinheiten erfolgen können.

Im Rahmen der erfindungsgemäßen Lösung wäre es ausreichend, mit den ersten Strahlungsfeldern des ersten Strahlungsfeldmusters in erfindungsgemäßer Weise zu arbeiten, wobei damit nur eine teilweise Überlagerung in gleicher Richtung ausgerichteter Strahlungsfelder möglich ist.

Um auch in einem Winkel, insbesondere quer zueinander ausgerichtete Strahlungsfeldmuster mit hoher Präzision überlagern zu können, ist vorzugsweise vorgesehen, daß die Vielzahl der erzeugbaren Strahlungsfelder ein zweites Strahlungsfeldmuster aus definiert relativ zueinander angeordneten zweiten erzeugbaren Strahlungsfeldern aufweist, deren Breitenausdehnungen parallel zu einer zweiten Richtung verlaufen.

Diese zweite Richtung verläuft dabei vorzugsweise in dem Winkel oder insbesondere quer zu der ersten Richtung.

Um dieselbe hohe Präzision wie bei den ersten Strahlungsfeldern zu erhalten ist vorzugsweise vorgesehen, daß das zweite Strahlungsfeldmuster von einem als Referenz dienenden zweiten Strahlungsfeld ausgehend in einer senkrecht zur Belichtungsbewegungsrichtung verlaufenden Querrichtung in unterschiedlichen Abständen angeordnete zweite Strahlungsfelder aufweist, das jedes zweite Strahlungsfeld des Strahlungsfeldmusters in der Querrichtung einen anderen Abstand von dem als Referenz dienenden zweiten Strahlungsfeld aufweist als die übrigen zweiten Strahlungsfelder und daß die Abständer aller zweiten Strahlungsfelder des zweiten Strahlungsfeldmusters eine Serie von Abständen bilden, bei der jeder Abstand um ein Inkrement größer als ein anderer der Abstände ist, und daß das Inkrement kleiner als eine Erstreckung der zweiten Strahlungsfelder in der Querrichtung ist.

Besonders günstig ist es hierbei, wenn das Inkrement maximal die Hälfte der Erstreckung der Strahlungsfelder in der Querrichtung beträgt.

Besonders günstig ist es, wenn das Strahlungsfeldmuster mindestens eine in einer Reihe angeordnete Serie von ersten Strahlungsfeldern umfaßt, die senkrecht zur Belichtungsbewegungsrichtung einen Abstand voneinander aufweisen, welcher kleiner als deren Ausdehnung senkrecht zur Belichtungsbewegungsrichtung ist.

Hiermit besteht die Möglichkeit, ein Lithographieverfahren zu schaffen, bei welchem innerhalb eines durch die Erstreckung der Serie senkrecht zur Belichtungsbewegungsrichtung liegenden Bereichs eine Erzeugung der Strahlungsfelder mit hoher Präzision möglich ist.

Vorzugsweise ist dabei vorgesehen, daß der Abstand zwischen den Strahlungsfeldern der Serie senkrecht zur Belichtungsbewegungsrichtung konstant ist.

Im einfachsten Fall sind dabei in der Serie die Strahlungsfelder in einer längs einer Geraden verlaufenden Reihe angeordnet.

Besonders günstig ist eine Lösung, bei welcher in der jeweiligen Reihe die Strahlungsfelder in Serienrichtung einen Abstand voneinander aufweisen, welcher größer ist als deren Erstreckung in Serienrichtung, so daß durch diesen Abstand noch ein Freiheitsgrad hinsichtlich der Anordnung der Strahlungsfelder in der Serienrichtung besteht.

Um zu erreichen, daß die Strahlungsfelder in der senkrecht zur Belichtungsbewegungsrichtung verlaufenden Querrichtung einen möglichst kleinen Abstand voneinander aufweisen, der möglichst kleiner als die Erstreckung der Lichtflecken in der Querrichtung ist, ist vorzugsweise vorgesehen, daß die Serienrichtung einen Winkel von ungleich 90°, beispielsweise kleiner als 90°, mit der Belichtungsbewegungsrichtung einschließt. Damit bewirkt die Projektion der in der Serie angeordneten Lichtflecken auf die senkrecht zur Belichtungsbewegungsrichtung verlaufende Querrichtung eine Verringerung des Abstandes in dem vorstehend genannten Maße.

Prinzipiell können bei dem erfindungsgemäßen Verfahren Halbleiterlaser eingesetzt werden, welche im blauen Spektralbereich oder im nahen UV Laserstrahlung erzeugen. Solange derartige Halbleiterlaser bislang nicht das für einen kommerziellen Einsatz erforderliche Preis-Leistungsverhältnis aufweisen, ist vorzugsweise vorgesehen, daß die Belichtungseinheit den Halbleiterlasern nachgeschaltete Frequenzverdoppler umfaßt. In diesem Fall ist es möglich, konventionelle im roten oder infraroten Spektralbereich arbeitende Halbleiterlaser einzusetzen und die Frequenz zu verdoppeln.

Im Zusammenhang mit der bisherigen Erläuterung der einzelnen Ausführungsbeispiele wurde nicht im einzelnen darauf eingegangen, wie die Laserstrahlung von den Halbleiterlasern zu der Strahlführungsoptik geführt werden soll da die Strahlführungsoptik und die Aufnahme relativ zueinander bewegbar sein müssen. Beispielsweise wäre es denkbar - wie bereits vorstehend erwähnt - die Halbleiterlaseranordnungen oder Halbleiterlaserarrays unmittelbar zu verwenden und ausgehend von diesem System mittels der Strahlführungsoptik die einzelnen Laserstrahlen auf die lichtempfindliche Schicht zur Erzeugung des Strahlungsfeldmusters abzubilden, so daß die Halbleiterlaser und die Strahlführungsoptik eine Einheit bilden und dabei diese Einheit und die Aufnahme relativ zueinander bewegbar sind.

Aufgrund der mit erheblichem Aufwand verbundenen und für Halbleiterlasereinheiten erforderlichen Betriebseinrichtungen ist dies jedoch vielfach nur begrenzt möglich. Aus diesem Grund ist vorteilhafterweise vorgesehen, daß die Belichtungseinheit die Laserstrahlung zur Strahlführungsoptik leitende Lichtleiter umfaßt, welche die Möglichkeit eröffnen, von weiter entfernt angeordneten Halbleiterlasern die Laserstrahlung möglichst verlustarm zur Strahlführungsoptik zu bringen, so daß in diesem Fall die Strahlführungsoptik und die Aufnahme die relativ zueinander bewegbaren Einheiten bilden.

Vorzugsweise werden für derartige Lichtleiter Monomodefasern eingesetzt und als Halbleiterlaser solche, welche im Singlemodebetrieb arbeiten.

Die Lichtleiter sind vorzugsweise so ausgebildet, daß sie ein erstes Ende aufweisen, in welches die Laserstrahlung einkoppelbar ist, und ein zweites Ende, aus welchem die Laserstrahlung austritt, und daß auf jedes zweite Ende folgend ein kollimierendes Element angeordnet ist, welches die divergent aus jedem einzelnen zweiten Ende der Lichtleiter austretende Laserstrahlung kollimiert und daraus ein kollimiertes Strahlungsbündel formt.

Eine derartige Lösung hat den großen Vorteil, daß die Möglichkeit besteht, das kollimierte Strahlungsbtindel optimal auf die lichtempfindliche Schicht abzubilden und somit einen möglichst kleinen Durchmesser des resultierenden Strahlungsfelds zu erhalten, wobei in diesem Fall vorzugsweise die zweiten Enden und die die kollimierende Optik umfassende Strahlführungsoptik eine Einheit bilden und diese Einheit und die Aufnahme relativ zueinander bewegbar sind.

Hinsichtlich der Ausbildung der Strahlführungsoptik wurden bislang keine näheren Angaben gemacht. So sieht ein vorteilhaftes Ausführungsbeispiel vor, daß die Strahlführungsoptik ein verkleinernd abbildendes Teleskop umfaßt. Mit einem derartigen Teleskop besteht die Möglichkeit, die technologiebedingt und hinsichtlich der zu erzeugenden Größe der Strahlungsfelder in großen Abständen mit den Halbleiterlasern erzeugte Laserstrahlung vorteilhafterweise so abzubilden, daß die Abstände zwischen den Strahlungsfeldern und die Strahlungsflecken selbst kleiner werden.

Mit einem derartigen Teleskop lassen sich in einfacher Weise Verkleinerungen von mehr als einem Faktor 10 erreichen.

Um insbesondere direkt lithographische Strukturen für die unmittelbare Herstellung eines integrierten Schaltkreises erzeugen zu können, ist vorteilhafterweise vorgesehen, daß die Strahlführungsoptik eine die Strahlungsfelder erzeugende Mikroskopoptik umfaßt. Eine derartige Mikroskopoptik bildet eine einfache Möglichkeit, eine möglichst starke Reduktion der Abstände zwischen den einzelnen Strahlungsfeldern zu erhalten.

Eine Mikroskopoptik hat jedoch den Nachteil, daß die Ausdehnung der Strahlungsfelder empfindlich von dem Abstand der Mikroskopoptik von der zu belichtenden Schicht abhängt. Aus diesem Grund ist vorteilhafterweise vorgesehen, daß die Mikroskopoptik an einer Höhenpositioniereinrichtung angeordnet ist und von dieser während der Belichtungsbewegung in einem definierten Abstand über der lichtempfindlichen Schicht positionierbar ist. Eine derartige Höhenpositioniereinrichtung schafft somit die Möglichkeit, die Nachteile einer derartigen Mikroskopoptik zu eliminieren oder möglichst gering zu halten.

Besonders zweckmäßig ist es, wenn ein Abstand zwischen einer der lichtempfindlichen Schicht zugewandten Unterseite der Mikroskopoptik und der lichtempfindlichen Schicht durch die Höhenpositioniereinrichtung einhaltbar ist.

Bevorzugterweise ist hierbei vorgesehen, daß der Abstand in der Größenordnung eines Durchmessers des einzelnen Strahlungsfelds auf der lichtempfindlichen Schicht liegt.

Mit den bislang beschriebenen Mikroskopoptiken besteht die Möglichkeit, beugungsbegrenzt Strahlungsfelder zu erhalten, deren Ausdehnung in der Größenordnung der Wellenlänge der Laserstrahlung liegt.

Um jedoch eine möglichst definierte Größe der einzelnen Lichtflecke, insbesondere im Bereich der Wellenlänge des eingesetzten Laserlichts oder kleiner, zu erhalten, ist vorzugsweise vorgesehen, daß die Mikroskopoptik mit einer die Größe der Strahlungsfelder auf der lichtempfindlichen Schicht definierenden Nahfeldoptik versehen ist.

Eine derartige Nahfeldoptik hat den großen Vorteil, daß sie aufgrund ihrer Nähe zu den auf der lichtempfindlichen Schicht erzeugten Strahlungsfelder die Möglichkeit eröffnet, weitgehend von der vorhergehenden Strahlführung unabhängig die endgültige Größe der Strahlungsfelder auf der lichtempfindlichen Schicht festzulegen.

Vorzugsweise ist dabei die Nahfeldoptik unmittelbar auf einer der lichtempfindlichen Schicht zugewandten Unterseite des Mikroskopobjektivs angeordnet, so daß der Abstand zwischen der Nahfeldoptik und der lichtempfindlichen Schicht sehr gering gehalten werden kann.

Die Nahfeldoptik kann dabei in unterschiedlichster Art und Weise ausgeführt sein.

So sieht ein Ausführungsbeispiel vor, daß die Nahfeldoptik die Strahlungsfelder der Strahlungsfeldmuster durch blendenähnliche Durchlaßbereiche definiert. In diesem Fall sind vorzugsweise blendenähnliche Durchlaßbereiche durch Bedampfen der Mikroskopoptik auf ihrer der lichtempfindlichen Schicht zugewandten Seite erreichbar.

Die Nahfeldoptik ist insbesondere dann vorteilhaft einsetzbar, wenn diese die Größe der Strahlungsfelder in zumindest einer Richtung auf Werte deutlich unter der Wellenlänge der Laserstrahlung reduziert.

In diesem Fall ist zweckmäßigerweise der Vektor des elektrischen Feldes E der Laserstrahlung so gelegt, daß dieser parallel zu der Richtung liegt, zu welcher die Ausdehnung der Strahlungsfelder kleiner als die Wellenlänge ist.

Da die flächenhafte Ausdehnung der Strahlungsfeldmuster nicht beliebig vergrößert werden kann, ohne daß die Strahlführungsoptik aufwendig ausgeführt werden muß, ist vorteilhafterweise zur Verkürzung der erforderlichen Belichtungszeiten vorgesehen, daß die Lithographie-Belichtungseinrichtung mehrere Strahlungsfeldmuster erzeugt.

Jedes Strahlungsfeldmuster weist dabei in einem definierten geometrischen Muster angeordnete Lichtflecken auf, wobei die mehreren Strahlungsfeldmuster beliebig zueinander angeordnet werden können.

Prinzipiell ist es denkbar, daß die mehreren Strahlungsfeldmuster in unterschiedlichen Belichtungsbewegungsrichtungen bewegbar sind.

Zur Vermeidung von Überkreuzbewegungen ist es vorteilhaft, wenn die mehreren Strahlungsfeldmuster parallel zu einer einzigen Belichtungsbewegungsrichtung bewegbar sind.

Die mehreren Strahlungsfeldmuster sind vorzugsweise während desselben Belichtungsvorgangs einsetzbar, so daß während eines Belichtungsvorgangs größere Teilbereiche der lichtempfindlichen Schicht belichtbar sind.

Prinzipiell wäre es möglich, die mehreren Strahlungsfeldmuster zeitversetzt zu erzeugen. Günstiger ist es jedoch, die mehreren Strahlungsfeldmuster im wesentlich zeitgleich zu generieren.

Insbesondere bei im wesentlichen zeitgleich generierten Strahlungsfeldmuster ist es von Vorteil, wenn für jedes Strahlungsfeldmuster eine eigene Mikroskopoptik vorgesehen ist.

Noch besser ist es, wenn für jedes Strahlungsfeldmuster eine eigene Strahlführungsoptik vorgesehen ist.

Die mehreren Strahlungsfeldmuster könnten prinzipiell aus einem Satz von Halbleiterlasern gespeist werden, insbesondere wenn mit jedem Strahlungsfeldmuster dieselben belichteten Teilbereiche erzeugt werden sollen.

Die Einsatzmöglichkeiten einer Lithographie-Belichtungseinrichtung sind jedoch größer, wenn für jedes Strahlungsfeldmuster ein eigener Satz von Halbleiterlasern zur Verfügung steht, so daß mit den Strahlungsfeldmustern unterschiedliche belichtete Teilbereiche erzeugbar sind.

Eine besonders einfach auszuführende Lösung sieht zur Erzeugung der mehreren Strahlungsfeldmuster mehrere Belichtungseinheiten vor, die selbständig arbeiten.

Die erfindungsgemäße Aufgabe wird bei einem Lithographieverfahren zum Herstellen von sich in einer Fläche erstreckenden Strukturen in einer lichtempfindlichen Schicht durch Belichten derselben mittels einer großen Zahl aufeinanderfolgender Belichtungsschritte zur Erzeugung einer Vielzahl von Umwandlungsbereichen in der lichtempfindlichen Schicht, die zusammen die Strukturen ergeben, wobei jeder Belichtungsschritt dazu dient, mittels eines Strahlungsfeldes innerhalb des Umwandlungsbereichs das die lichtempfindliche Schicht bildende Material von einem unbelichteten Ausgangszustand in den umgewandelten Endzustand zu überführen und wobei das Strahlungsfeld durch Fokussieren von Laserstrahlung und zusätzliches Begrenzen der Laserstrahlung in einer Breitenrichtung mittels einer senkrecht zur Breitenrichtung langgestreckten Blendenöffnung in der lichtempfindlichen Schicht mit einer wirksamen Ausdehnung in der Breitenrichtung erzeugt wird, die in der Größenordnung der Wellenlänge der Laserstrahlung oder kleiner ist erfindungsgemäß dadurch gelöst, daß zur Herstellung eines Teils der Umwandlungsbereiche Strahlungsfelder mit einer Energieverteilung eingesetzt werden, die es erforderlich macht, daß mindestens die Einwirkung zweier Strahlungsfelder auf denselben Umwandlungsbereich in der lichtempfindlichen Schicht erforderlich ist, um in diesem das Material der lichtempfindlichen Schicht in den Endzustand zu überführen.

Der Vorteil des erfindungsgemäßen Verfahrens ist darin zu sehen, daß die Möglichkeit besteht, Umwandlungsbereiche mit einer Ausdehnung zu erhalten, die in mindestens einer Richtung kleiner ist als die Ausdehnung der hierzu eingesetzten Strahlungsfelder.

Besonders günstig ist es dabei, wenn die mindestens zwei Strahlungsfelder überlappend auf die lichtempfindliche Schicht einwirken und daß ein Überlappungsbereich derselben den Umwandlungsbereich überdeckt.

Dabei können die beiden teilweise überlappenden Strahlungsfelder mit ihren Breitenrichtungen parallel zueinander verlaufen.

Besonders vorteilhaft läßt sich ein derartiges teilweises Überlappen jedoch dann erreichen, wenn ein erstes Strahlungsfeld der auf denselben Umwandlungsbereich wirkenden Strahlungsfelder die wirksame Ausdehnung in einer Breitenrichtung längs einer ersten Richtung aufweist und daß ein zweites Strahlungsfeld der auf denselben Umwandlungsbereich wirkenden Strahlungsfelder eine wirksame Ausdehnung in einer Breitenrichtung aufweist, die längs einer zweiten, im Winkel zur ersten Richtung verlaufenden Richtung verläuft.

Dabei besteht die Möglichkeit, die teilweise überlappenden Strahlungsfelder so anzuordnen, daß sie sich mit endseitigen Bereichen überlappt. Besonders günstig ist es jedoch, wenn die Strahlungsfelder so überlagert werden, daß die Überlagerung in dem Mittenbereich mindestens eines der Strahlungsfelder erfolgt.

Werden mehr als zwei Strahlungsfelder überlagert, so ist dabei vorzugsweise vorgesehen, daß diese Strahlungsfelder alle bezüglich eines ausgewählten Strahlungsfeldes in einem unterschiedlichen Winkel angeordnet werden.

Vorzugsweise sind bei mehreren Strahlungsfeldern die Strahlungsfelder so angeordnet, daß in einer Drehrichtung aufeinanderfolgende Strahlungsfelder in ungefähr dem gleichen Winkelabstand zueinander angeordnet sind.

Hinsichtlich der zeitlichen Einwirkung der Strahlungsfelder wurden bislang keine näheren Angaben gemacht. So wäre es bei einer Lösung denkbar, daß die Strahlungsfelder zeitlich aufeinanderfolgend auf den Umwandlungsbereich einwirken, wobei in diesem Fall Voraussetzung ist, daß das Material der lichtempfindlichen Schicht so ist, daß die Einwirkung des ersten Strahlungsfeldes, obwohl diese noch nicht zu einer Umwandlung des Materials in den umgewandelten Endzustand geführt hat, erhalten bleibt und sich die Wirkung der beiden Strahlungsfelder, auch wenn diese zeitlich aufeinanderfolgend eintritt, addiert, so daß insgesamt nach der Einwirkung mindestens des zweiten Strahlungsfeldes oder auch der weiteren Strahlungsfelder die Umwandlung des Materials der lichtempfindlichen Schicht in den umgewandelten Zustand erreicht wird.

Weiterhin wäre es denkbar, daß die Strahlungsfelder zeitlich überlappend auf den Umwandlungsbereich einwirken, so daß das Material der lichtempfindlichen Schicht die Einwirkung des ersten Strahlungsfeldes insoweit noch speichert bis das zweite Strahlungsfeld eingewirkt hat.

Eine weitere vorteilhafte Lösung des erfindungsgemäßen Lithographieverfahrens sieht vor, daß die Strahlungsfelder im wesentlichen gleichzeitig auf den Umwandlungsbereich einwirken, diese Lösung ist insbesondere des Zeitaufwandes für das erfindungsgemäße Lithographieverfahren von Vorteil und in dem Fall, in dem möglichst die Intensität beider Strahlungsfelder gleichzeitig einwirken soll.

Weitere Merkmale und Vorteile der erfindungsgemäßen Lösung sind Gegenstand der nachfolgenden Beschreibung sowie der zeichnerischen Darstellung einiger Ausführungsbeispiele.

In der Zeichnung zeigen:
- Fig. 1: eine schematische Ansicht eines ersten Ausführungsbeispiels einer Lithographie-Belichtungseinrichtung;
- Fig. 2: eine vergrößerte Schnittdarstellung des ersten Ausführungsbeispiels im Bereich einer Nahfeldoptik mit einer parallel zur Breite einer Blendenöffnung liegenden Schnittebene;
- Fig. 3: einen Schnitt ähnlich Fig. 3 in einer parallel zu einer Längsrichtung der Blendenöffnung liegenden Schnittebene;
- Fig.4: ein erstes Ausführungsbeispiel eines ersten Strahlungsfeldmusters erzeugbar durch das erste Ausführungsbeispiel der Lithographie-Belichtungseinrichtung gemäß Fig. 1;
- Fig. 5: ein zweites Ausführungsbeispiel des ersten Strahlungsfeldmusters erzeugbar durch das erste Ausführungsbeispiel der Lithographie-Belichtungseinrichtung gemäß Fig. 1;
- Fig. 6: eine ausschnittsweise Darstellung einer Variante des ersten Ausführungsbeispiels der Lithographie-Belichtungseinrichtung;
- Fig.7: eine beispielhafte Darstellung einer Struktur der lichtempfindlichen Schicht im Zusammenhang mit einem ersten Ausführungsbeispiel der erfindungsgemäßen Lösung;
- Fig. 8: eine Darstellung eines zweiten Ausführungsbeispiels der erfindungsgemäßen Lösung, ausgeführt mit einem zweiten Ausführungsbeispiel der Lithographie-Belichtungseinrichtung;
- Fig. 9: eine Darstellung der Überlagerung zweier Strahlungsfelder beim zweiten Ausführungsbeispiel der erfindungsgemäßen Lösung;
- Fig. 10: eine Darstellung eines dritten Ausführungsbeispiels der erfindungsgemäßen Lösung, ausgeführt mit einem dritten Ausführungsbeispiel der erfindungsgemäßen Lithographie-Belichtungseinrichtung;
- Fig. 11: eine Darstellung der Überlagerung zweier Strahlungsfelder beim dritten Ausführungsbeispiel der erfindungsgemäßen Lösung;
- Fig. 12: eine Darstellung eines vierten Ausführungsbeispiels der erfindungsgemäßen Lösung und
- Fig. 13: eine Darstellung der Überlagerung der Strahlungsfelder beim vierten Ausführungsbeispiel der erfindungsgemäßen Lösung.

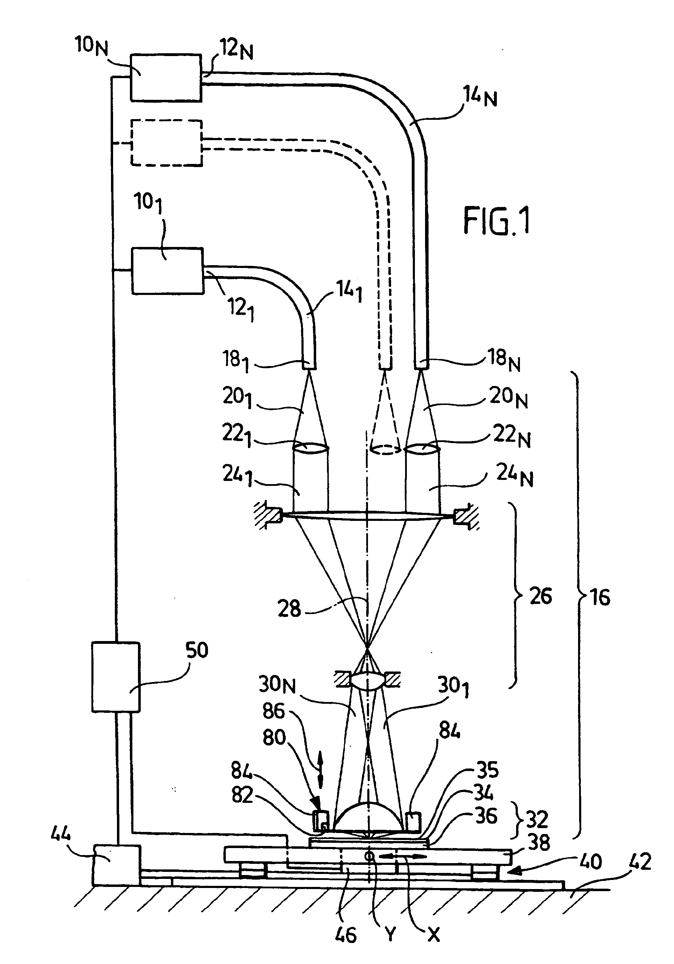

Ein erstes Ausführungsbeispiel einer Lithographie-Belichtungseinrichtung, dargestellt in Fig. 1, umfaßt eine Vielzahl von Lasereinheiten 10₁ bis 10_{N}, welche Halbleiterlaser umfassen und vorzugsweise Laserstrahlung im blauen Spektralbereich erzeugen, die in erste Enden 12₁ bis 12_{N} von Lichterleitern 14₁ bis 14_{N}, vorzugsweise Singlemodefasern, eintritt, von diesen zu einer als Ganzes mit 16 bezeichneten Strahlführungsoptik geführt wird und zum Eintritt in die Strahlführungsoptik 16 aus zweiten Enden 18₁ bis 18_{N} der Lichtleiter 14₁ bis 14_{N} austritt, wobei die zweiten Enden 18₁ bis 18_{N} und die Strahlführungsoptik vorzugsweise eine in sich starre optische Einheit bilden. Die Laserstrahlung tritt aus den zweiten Enden 18₁ bis 18_{N} der Lichtleiter 14₁ bis 14_{N} in Form von divergenten Strahlenbündeln 20₁ bis 20_{N} aus und wird durch jeweils kollimierende Elemente 22₁ bis 22_{N} zu jeweils kollimierten Strahlungsbündeln 24₁ bis 24_{N} geformt.

Diese kollimierten Strahlungsbündel 24₁ bis 24_{N} werden durch eine von der Strahlführungsoptik 16 umfaßte Teleskopoptik 26 so abgebildet, daß deren Abstand von einer Mittelachse oder Symmetrieachse 28 verkleinert wird.

Aus der Teleskopoptik 26 treten nun wiederum divergente Strahlungsbündel 30₁ bis 30_{N} aus, die dann ihrerseits von einer Mikroskopoptik 32 auf eine lichtempfindliche Schicht 34, aufgebracht auf einem Substrat 36 abgebildet werden, wobei es zum Erhalt einer präzisen Abbildung erforderlich ist, daß die Strahlführungsoptik 16 mit deren zweiten Enden 18₁ bis 18_{N}, den kollimierenden Elementen 22₁ bis 22_{N}, der Teleskopoptik 26 sowie der Mikroskopoptik 32 eine in sich invariable optische Einheit bildet.

Das Substrat 36 ist seinerseits auf einem eine Aufnahme bildenden Verschiebetisch 38 fixiert, wobei der Verschiebetisch 38 als in zwei senkrecht zueinander verlaufende Richtungen X und Y verschieblich mittels einer Kreuzschlitteneinrichtung 40 auf einer Basis 42 fixiert ist. Zur exakten Verschiebung des Verschiebetisches 38 relativ zur Basis 42 sind zwei Stellantriebe mit Wegmeßsystemen 44 und 46 vorgesehen, welche über eine Steuerung 50 ansteuerbar sind.

Mit der Steuerung 50 sind ferner sämtliche Lasereinheiten 10₁ bis 10_{N} ebenfalls ansteuerbar.

Zur Erzeugung der Relativbewegung zwischen dem Substrat 36 und der Strahlführungsoptik 16, ist vorzugsweise die gesamte Strahlführungsoptik 16 relativ zur Basis 42 fest angeordnet, so daß einzig das Substrat 36 mit der darauf angeordneten lichtempfindlichen Schicht 34 relativ zur Strahlführungsoptik 16 beweglich ist.

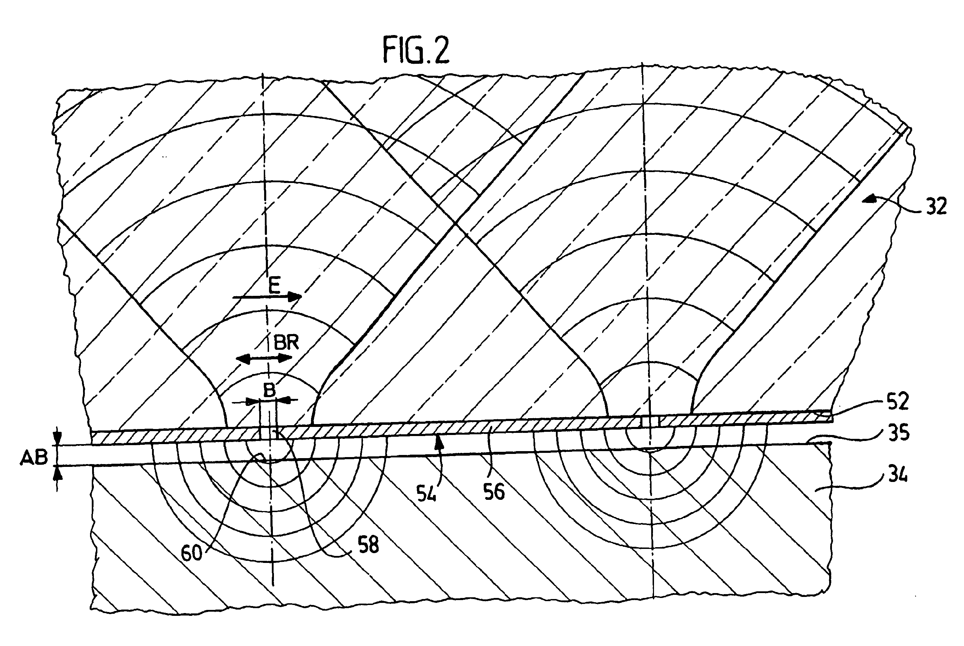

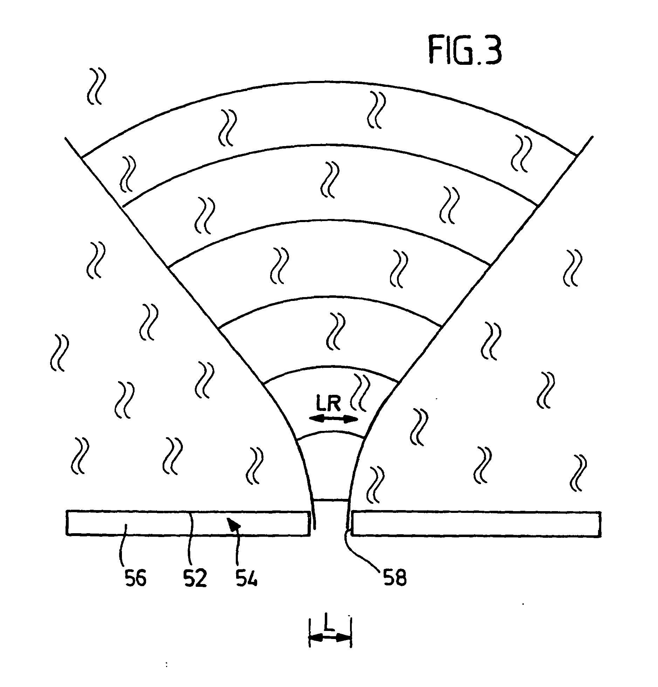

Bei der Lösung, dargestellt in Fig. 2 und 3, ist die Mikroskopoptik 32 auf ihrer der lichtempfindlichen Schicht 34 zugewandten Seite 52 mit einer Nahfeldoptik 54 versehen, welche in dem Bereich angeordnet ist, in welchem die durch die Mikroskopoptik 32 verkleinert abgebildete Laserstrahlung aus dieser austritt. Die Nahfeldoptik 54 kann dabei in unterschiedlichster Art und Weise ausgebildet sein.

Wie in Fig. 2 und 3 dargestellt, wird die Nahfeldoptik 54 vorzugsweise durch eine als Blende 56 wirkende Beschichtung gebildet, welche reflektierend oder absorbierend ausgebildet ist und eine Blendenöffnung 58 aufweist, durch welche dann die Laserstrahlung austritt. Mit der Blendenöffnung 58 ist dabei unabhängig von der Strahlformung durch die übrige Mikroskopoptik 32 die räumliche Ausdehnung von aus diesen austretenden Strahlungsfeldern 60 festlegbar. Dabei sind die blendenähnlichen Öffnungen 58 so dimensioniert, daß die Strahlungsfelder 60 in zumindest einer Breitenrichtung BR eine in der lichtempfindlichen Schicht 34 wirksame Ausdehnung aufweisen, die in der Größenordnung der verwendeten Wellenlänge des Laserlichts oder kleiner ist. Somit sind in der Breitenrichtung BR beispielsweise Ausdehnungen der Strahlungsfelder 60 in der Größenordnung bis zu mehreren 100, aber auch kleiner 200 oder noch besser kleiner 100 Nanometer, erreichbar, wobei in diesem Fall die eintretende Lichtwelle einen Vektor des elektrischen Feldes E aufweisen muß, welcher parallel zur Breite B verläuft, die eine derartige Dimension aufweist.

In ihrer Längsrichtung LR, senkrecht zur Breite B, haben die Blendenöffnungen 58 dann vorzugsweise eine Ausdehnung L aufzuweisen, die mindestens in der Größenordnung der Wellenlänge der Laserstrahlung liegt und mindestens der Ausdehnung des B-Feldes der Lichtwelle entspricht, vorzugsweise jedoch ein Mehrfaches der Breite B beträgt.

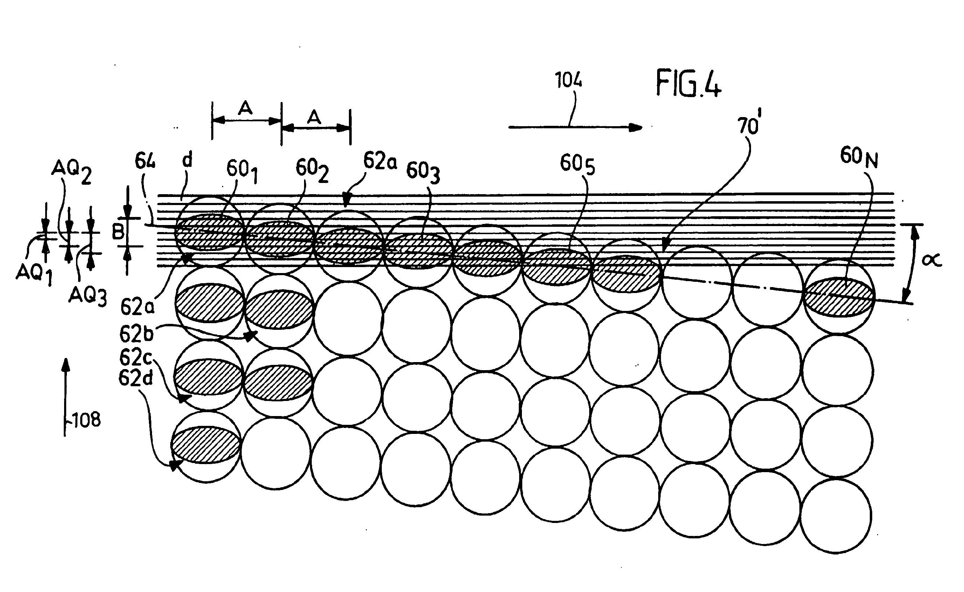

Wie in Fig. 4 dargestellt, wird die Laserstrahlung durch die Mikroskopoptik 32 beispielsweise so auf eine Oberfläche 54 der lichtempfindlichen Schicht 34 abgebildet, daß eine Vielzahl von ersten Strahlungsfeldern 60₁ bis 60_{N} entsteht, die jeweils dieselbe Breite B und dieselbe Länge L sowie eine ungefähr parallele Ausrichtung der Breitenrichtungen BR relativ zueinander aufweisen und in einem konstanten Abstand A voneinander als Serie 62 längs einer Serienrichtung 64 angeordnet sind und dadurch ein erstes Strahlungsfeldmuster 70 auf der Oberfläche 54 bilden.

Durch die Bewegung des Substrats 36 in der X- und/oder Y-Richtung ist das gesamte erste Strahlungsfeldmuster 70 über die lichtempfindliche Schicht 34, welche das Substrat 36 bedeckt, hinwegbewegbar und zwar so, daß jeder Punkt der gesamten Oberfläche 54 durch mindestens ein Strahlungsfeld 60 belichtet werden kann.

Vorzugsweise ist das Substrat 36 ein Wafer üblicher Größe, auf welchem, eine Vielzahl von lithographischen Strukturen, beispielsweise für Halbleiterbauelemente, erzeugt werden soll.

Das aus der Blendenöffnung 58 austretende Strahlungsfeld 60 ist aufgrund der Größe der Blendenöffnung 58 nicht mehr mit den Gesetzen der geometrischen Optik beschreibbar, sondern eher mit einer Kugelwelle, wie in Fig. 2 dargestellt, wobei in diesem Fall die Kugelwelle die Dimension des Strahlungsfeldes 60 auf der Oberfläche 35 der lichtempfindlichen Schicht 34 bestimmt.

Aus diesem Grund ist es erforderlich, die Mikroskopoptik 32 mit einer Höhenverstelleinrichtung 80 zu versehen, welche die Nahfeldoptik 54 in einem definierten Abstand AB über der Oberfläche 35 der lichtempfindlichen Schicht 34 während der Belichtungsbewegungen in einer Belichtungsbewegungsrichtung 104 führt. Die Höhenverstelleinrichtung 80 hält dabei vorzugsweise die Nahfeldoptik 54 und somit die gesamte Mikroskopoptik 32 in einem Abstand AB über der Oberfläche 35 der lichtempfindlichen Schicht 34, welcher ungefähr in der Größenordnung der Wellenlänge des Laserlichts liegt. Damit ist sichergestellt, daß die räumliche Ausdehnung des Strahlungsfeldes 60 nicht dadurch verändert wird, daß sich der Abstand AB zwischen der Oberfläche 35 und der Nahfeldoptik 54 während der Belichtungsbewegung in Belichtungsbewegungsrichtung 104 wesentlich ändert (Fig. 1).

Vorzugsweise arbeitet eine derartige Höhenverstelleinrichtung 80 mit einem Sensor 82, welcher stets den Abstand AB von der Oberfläche 35 erfaßt, und einem Stellglied 84, welches vorzugsweise die gesamte Mikroskopoptik 32 in einer Höhenrichtung 86 senkrecht zur Oberfläche 35 verstellt (Fig. 1).

Mit einer derartigen Höhenverstelleinrichtung 80 sind somit auch Variationen in der Dicke des Substrats 36 sowie der Dicke der lichtempfindlichen Schicht 34 ausgleichbar.

Bei dem vom ersten Ausführungsbeispiel der Lithographie-Belichtungseinrichtung erzeugbaren ersten Ausführungsbeispiel eines in Fig. 4 dargestellten ersten Strahlungsfeldmusters 70 sind die von ersten Strahlungsfeldern 60 festlegenden Blendenöffnungen 58 so angeordnet, daß deren Breitenrichtungen BR alle parallel zueinander verlaufen und folglich auch alle Längsrichtungen LR parallel zueinander ausgerichtet sind.

Vorzugsweise verlaufen ferner die Längsrichtungen LR parallel zu einer Belichtungsbewegungsrichtung 104, so daß auch die ersten Strahlungsfelder 60 parallel zu dieser ausgerichtet sind.

Um ein möglichst feines Schreibraster in einer senkrecht zu der Belichtungsbewegungsrichtung 104 verlaufenden Querrichtung 108 zu erhalten, ist bei dem ersten Ausführungsbeispiel, wie in Fig. 4 dargestellt, die Serienrichtung 64 der Serie 62 in einem derart spitzen Winkel α relativ zur Belichtungsbewegungsrichtung 104 angeordnet, daß aufeinanderfolgende Strahlungsfelder 60₁, 60₂ oder 60₂, 60₃ usw. in der Querrichtung 108 um einen dem Inkrement d entsprechenden Bruchteil der Breite B der Strahlungsfelder 60 verschoben ist, so daß sich, wie im Ausführungsbeispiel gemäß Fig. 4 dargestellt, beispielsweise ein Schreibraster mit Inkrement d erreichen läßt, welche ein Viertel der wirksamen Breite B der Strahlungsfelder 60 darstellt. Das heißt, daß das Strahlungsfeld 60₅ der Serie 62 gegenüber dem Strahlungsfeld 60₁ um die Breite 4 x d = B in der Querrichtung 108 verschoben ist.

Es sind aber auch gröbere oder feinere Schreibraster denkbar, wobei die durch das Inkrement d bestimmte Schreibraster mindestens ein Drittel von B betragen sollte, um eine ausreichende Feinheit des Schreibrasters in der Querrichtung 108 senkrecht zur Belichtungsbewegungsrichtung 104 zu erhalten.

Vorzugsweise ist in diesem Fall das Strahlungsfeldmuster 70 durch eine Vielzahl von parallel zueinander verlaufenden Serien 62ₐ bis 62_{d} von Strahlungsfeldern 60 gebildet, wobei innerhalb jeder Serie von Strahlungsfeld zu Strahlungsfeld ein vorgegebenes Inkrement d in der Querrichtung 108 besteht.

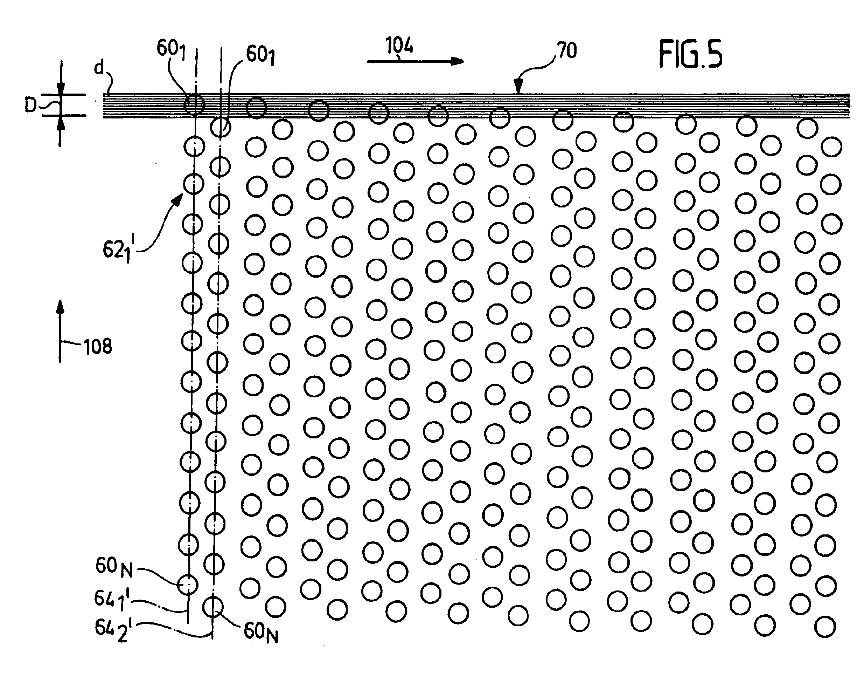

Bei einem vom ersten Ausführungsbeispiel der Lithographie-Belichtungseinrichtung erzeugbaren Variante des zweiten Ausführungsbeispiels eines ersten Strahlungsfeldmusters 70', dargestellt in Fig. 5, erstrecken sich die Serienrichtungen 64' der einzelnen Serien 62' senkrecht zu Belichtungsbewegung 104, die Strahlungsfelder 60 der einzelnen Serien 62' sind jedoch so gegeneinander versetzt, daß im gesamten ersten Strahlungsfeldmuster 70' zu jedem Strahlungsfeld 60 ein weiteres Strahlungsfeld existiert, welches um ein Inkrement d in der Querrichtung 108 senkrecht zur Belichtungsbewegungsrichtung 104 versetzt ist.

Somit ist insgesamt mit einem derartigen Lichtfleckmuster 70' die Möglichkeit gegeben, mit einer Auflösung d in der Querrichtung 108 zu arbeiten. Innerhalb der durch das Strahlungsfeldmuster 70' vorgegebenen Musterausdehnung senkrecht zur Belichtungsbewegungsrichtung 104 ist dabei eine präzise Belichtung des Substrats 36 möglich, da die relative Anordnung der ersten Strahlungsfelder 60 zueinander und die Größe derselben unverändert bestehen bleiben.

Hernach ist - sofern sich das Lichtfleckmuster 70' nicht bereits in der Querrichtung 108 über das gesamte Substrat 36 erstreckt - das Lichtfleckmuster 70' als Ganzes in der Querrichtung 108 um eine Distanz zu versetzen, welche der Musterausdehnung des Lichtfleckmusters 70' in der Querrichtung 108 entspricht, wobei bei jedem Überfahren der lichtempfindlichen Schicht 34 eine Belichtung über die gesamte Musterausdehnung des Lichtfleckmusters 70' in der Querrichtung 108 möglich ist, so daß zum Belichten der gesamten lichtempfindlichen Schicht 34 auf dem Substrat 36 wenige Belichtungsbewegungen des Lichtfleckmusters 70' in der Belichtungsbewegungsrichtung 104 erforderlich sind, deren Zahl sich aus der Erstreckung der lichtempfindlichen Schicht 34 in der Querrichtung 108 dividiert durch die Musterausdehnung des Lichtfleckmusters 70' in dieser Richtung ergibt.

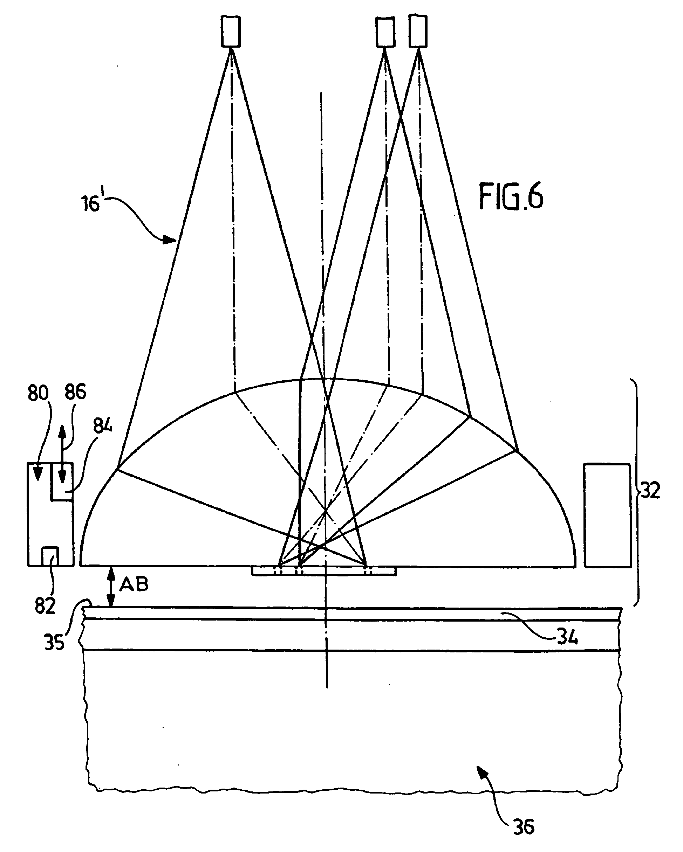

Bei einer Variante des ersten Ausführungsbeispiels einer Lithographie-Belichtungseinrichtung, dargestellt in Fig. 6, ist vorgesehen, daß die von den Lasereinheiten 10₁ bis 10_{N} ausgehenden Lichtleiter 14₁ bis 14_{N} zu einer Strahlführungsoptik 16' führen, welche lediglich die Mikroskopoptik 32 umfaßt. In diesem Fall sind die einzelnen Lichtleiter 14₁ bis 14_{N} nebeneinanderliegend so dicht angeordnet, daß die aus diesen austretende divergente Laserstrahlung 20₁ bis 20_{N} unmittelbar in die Mikroskopoptik 32 eintreten kann und keinerlei weiterer vorheriger Verkleinerung bedarf.

Alternativ zum Vorsehen nebeneinanderliegender Faserenden 18₁ bis 18_{N} ist es bei einer weiteren Variante des ersten Ausführungsbeispiels einer Lithographie-Belichtungseinrichtung denkbar, unmittelbar eine Halbleiterlaseranordnung, beispielsweise in Form von Vertikalemittern, eingangsseitig der Mikroskopoptik 32 anzuordnen.

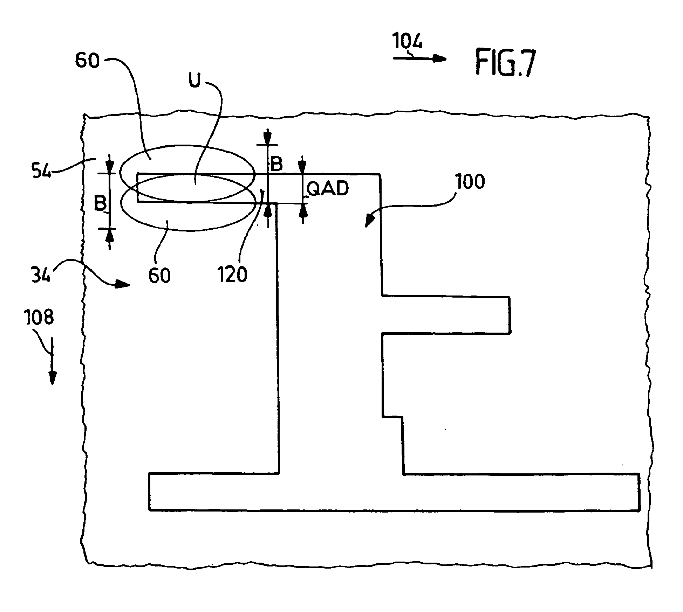

Bei einem ersten Ausführungsbeispiel einer erfindungsgemäßen Lösung wird das erste Strahlungsfeldmuster 70 oder 70' mit Lithographie-Belichtungseinrichtungen gemäß einem der voranstehenden ersten Ausführungsbeispielen erzeugt, mit welchem, wie in Fig. 7 dargestellt, in der lichtempfindlichen Schicht 34 eine sich in einer Fläche erstreckende Struktur 100 für ein Halbleiterbauelement dadurch mit einer Form herstellbar ist, welche in einem Teilbereich 102 quer zur Belichtungsbewegungsrichtung 104 eine Querausdehnung QAD aufweist, die kleiner ist als die wirksame Breite B eines Strahlungsfeldes 60, daß zwei um ein Inkrement n x d in der Querrichtung 108 versetzte Strahlungsfelder 60 überlappend eingesetzt werden und beide eine derartige Intensitätsverteilung aufweisen, daß eine einmalige Belichtung des Materials der lichtempfindlichen Schicht 34 nicht ausreichend ist, um diese von einem unbelichteten Ausgangszustand in den umgewandelten Endzustand zu überführen. Vielmehr ist die Intensität so gewählt, daß mindestens zwei überlappend wirkende Strahlungsfelder 60 erforderlich sind, um in dem Überlappungsbereich, in welchem sich die Intensität der beiden Strahlungsfelder 60 addiert, zu einer Umwandlung des Materials der lichtempfindlichen Schicht 34 in den umgewandelten Endzustand zu führen. Dadurch wird erreicht, daß lediglich im Überlappungsbereich der zwei Strahlungsfelder 60 der Umwandlungsbereich U entsteht, in welchem das Material der lichtempfindlichen Schicht 34 in den umgewandelten Zustand überführt ist.

Dadurch, daß sich nun die beiden Strahlungsfelder 60 überlappen, jedoch versetzt anordnen lassen, besteht die Möglichkeit, einen Umwandlungsbereich U zu erhalten, welcher in der Querrichtung 108 eine Ausdehnung QAD aufweist, die kleiner ist als die Ausdehnung, das heißt im vorliegenden Fall die Breite B, der Strahlungsfelder 60 in dieser Richtung.

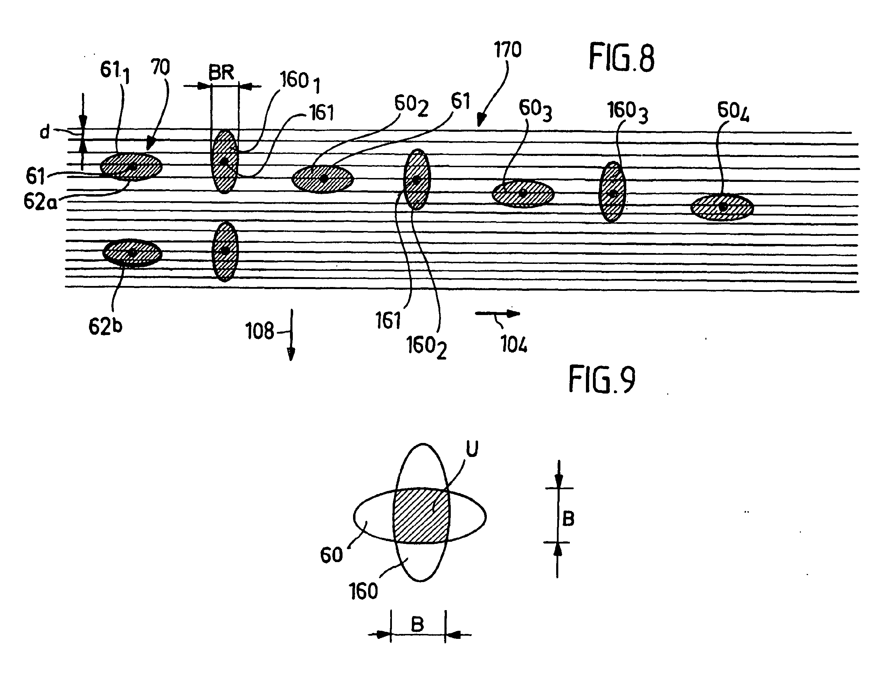

Bei einem zweiten Ausführungsbeispiel einer erfindungsgemäßen Lösung, schematisch dargestellt in Fig. 8, ist das erste Strahlungsfeldmuster 70 in gleicher Weise angeordnet wie beim ersten Ausführungsbeispiel der erfindungsgemäßen Lösung. Allerdings ist zusätzlich noch ein zweites Strahlungsfeldmuster 170 mit zweiten Strahlungsfeldern 160 vorgesehen, die in gleicher Weise angeordnet sind wie beim ersten Strahlungsfeldmuster 70, allerdings verläuft deren Breitenrichtung BR innerhalb des zweiten Strahlungsfeldmusters 170 parallel zur Belichtungsbewegungsrichtung 104.

Vorzugsweise sind dabei das erste Strahlungsfeldmuster 70 und das zweite Strahlungsfeldmuster 170 ineinander verschachtelt angeordnet und zwar so, daß in einer Reihe 62 jeweils auf ein erstes Strahlungsfeld 60 ein zweites Strahlungsfeld 160 folgt, deren Mitten 61 und 161 auf einer zur Belichtungsbewegungsrichtung 104 parallelen Gerade liegen. Dann folgt wiederum das nächste erste Strahlungsfeld 60₂, welches gegenüber dem vorangehenden ersten Strahlungsfeld 60₁ um das Inkrement d in der Querrichtung 108 verschoben ist und auf diesen das nächste zweite Strahlungsfeld 160₂, das in gleicher Weise um das Inkrement d in der Querrichtung 108 verschoben ist.

Mit derartig vorgesehenen ersten Strahlungsfeldern 60 und zweiten Strahlungsfeldern 160 läßt sich dann, wenn die Intensitätsverteilung in beiden Strahlungsfeldern 60, 160 so ist, daß eine einmalige Einwirkung eines der Strahlungsfelder 60, 160 nicht zur vollständigen Umwandlung des Materials der lichtempfindlichen Schicht 34 führt, ein Umwandlungsbereich U durch überlappende Positionierung eines der ersten Strahlungsfelder 60 und eines der zweiten Strahlungsfelder 160 erhalten, der in X-Richtung und Y-Richtung eine Ausdehnung aufweist, welche ungefähr der Breite B der Strahlungsfelder 60, 160 entspricht. Damit läßt sich ein im wesentlichen quadratförmiger Umwandlungsbereich U erreichen, welcher in allen Richtungen eine Ausdehnung in der Größenordnung der Wellenlänge des Laserlichts oder kleiner aufweist.

Bei dem in Fig. 8 dargestellten zweiten Ausführungsbeispiel der erfindungsgemäßen Lösung ist für die Erzeugung jedes ersten Strahlungsfeldes 60 und jedes zweiten Strahlungsfeldes 160 bei einem zweiten Ausführungsbeispiel einer Lithographie-Belichtungseinrichtung jeweils eine eigene Blendenöffnung 58 mit entsprechender Ausrichtung derselben erforderlich, wobei vorzugsweise jeder der Blendenöffnungen 58 eine eigene, hinsichtlich ihrer Leistung in den erwünschten Zeiträumen ansteuerbare Strahlungsquelle zugeordnet ist, um das erste Strahlungsfeld 60 und das zweite Strahlungsfeld 160 so zu positionieren, daß sich deren Einwirkungsbereiche in der lichtempfindlichen Schicht 34 überlappen und somit durch die Überlappung der Umwandlungsbereich U gebildet wird (Fig. 9).

Da gemäß dem zweiten Ausführungsbeispiel der erfindungsgemäßen Lösung bereits zum Herstellen eines Umwandlungsbereichs U eine Bewegung der Mikroskopoptik 32 mit der Nahfeldoptik 54 und zwei Belichtungsschritte erforderlich sind, ist in gleicher Weise wie beim ersten Ausführungsbeispiel eine derartige Vorgehensweise zeitaufwendig.

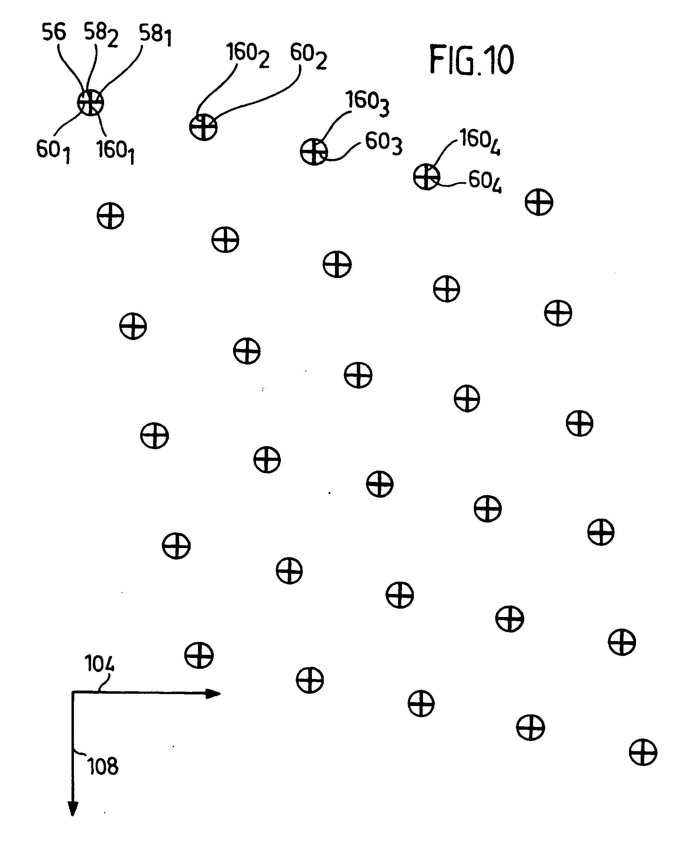

Aus diesem Grund sieht ein in Fig. 10 dargestelltes drittes Ausführungsbeispiel einer erfindungsgemäßen Lösung vor, daß jede Blende 56 eines dritten Ausführungsbeispiels der Lithographie-Belichtungseinrichtung zwei einander überkreuzende Blendenöffnungen 58₁ und 58₂ aufweist und somit in der Lage ist, sowohl ein erstes Strahlungsfeld 60 als auch ein zweites Strahlungsfeld 160 hinsichtlich seiner wirksamen Ausdehnung räumlich festzulegen.

Damit entfällt bei einem derartigen dritten Ausführungsbeispiel der Lithographie-Belichtungseinrichtung die Notwendigkeit, die Mikroskopoptik 32 mit der Nahfeldoptik in der Belichtungsbewegungsrichtung 104 zu bewegen, um einen einzigen Umwandlungsbereich U zu erzeugen.

Allerdings ist es bei diesem dritten Ausführungsbeispiel der Lithographie-Belichtungseinrichtung erforderlich, durch die Lichtleiter 14 Laserstrahlung mit zwei Polarisationsrichtungen zur Mikroskopoptik 32 zu führen. Aus diesem Grund sind vorzugsweise jedem der Lichtleiter 14 zwei Lasereinheiten 10_{N1} und 10_{N2} zugeordnet, wobei die Lasereinheit 10_{N1} beispielsweise Laserstrahlung liefert, deren E-Vektor parallel zur Breitenrichtung BR der ersten Blendenöffnung 58₁ verläuft und ein erstes Strahlungsfeld 60 bildet, während die zweite Lasereinheit 10 Laserstrahlung mit einer Polarisation liefert, deren E-Vektor parallel zur Breitenrichtung BR der zweiten Blendenöffnung 58₂ verläuft und ein zweites Strahlungsfeld 160 bildet.

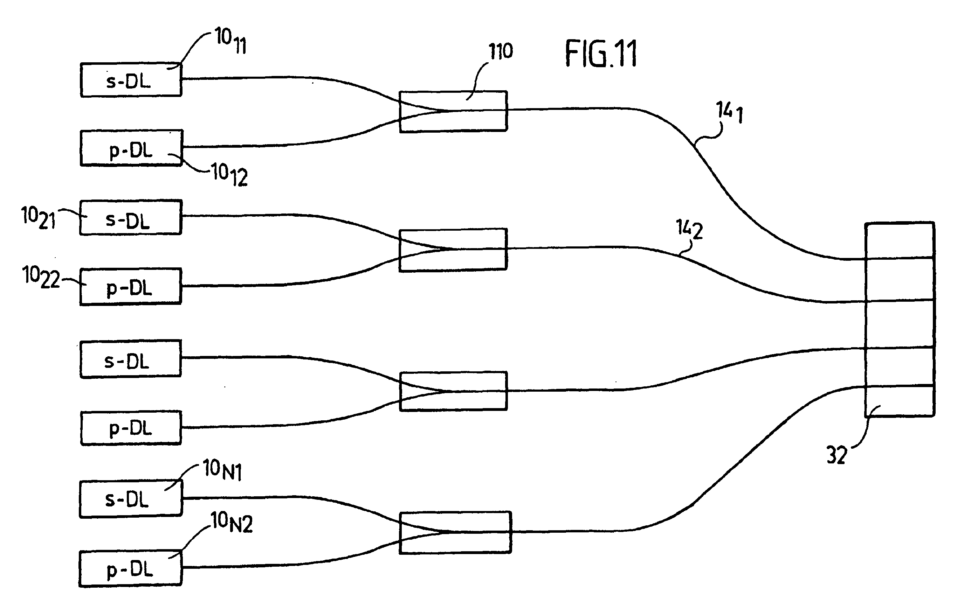

Dabei lassen sich die Lasereinheiten 10_{N1} und 10_{N2} von der Steuerung 50 entweder gleichzeitig oder zeitlich überlappend oder auch zeitlich nacheinander betreiben, um gegebenenfalls das erste Strahlungsfeld 60 und das zweite Strahlungsfeld 160 zu erzeugen (Fig. 11).

Die Laserstrahlung der beiden Lasereinheiten 10_{N1} und 10_{N2} wird vorzugsweise durch einen Polarisationsfaserkoppler 110 in den entsprechenden Lichtleiter 14 eingekoppelt.

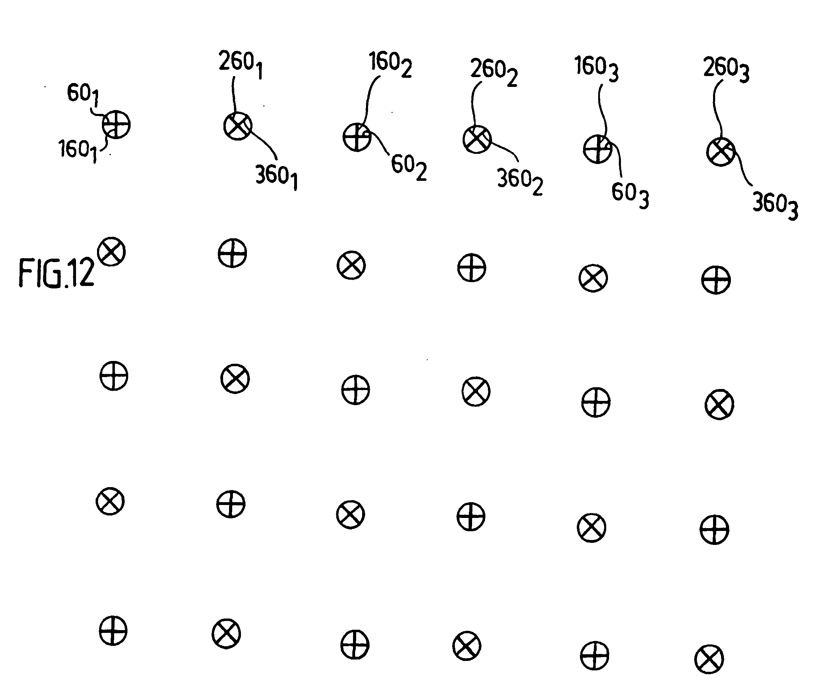

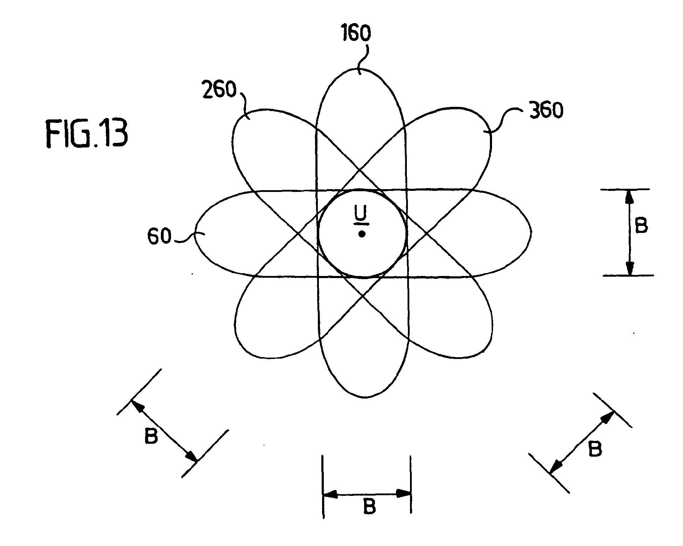

Bei einem vierten Ausführungsbeispiel der erfindungsgemäßen Lösung, ausgeführt mit einem vierten Ausführungsbeispiel einer erfindungsgemäßen Lithopraphie-Belichtungseinrichtung ist, wie in Fig. 12 dargestellt, nicht nur das Überlagern des ersten Strahlungsfelds 60 mit dem zweiten Strahlungsfeld 160 vorgesehen, sondern es ist zusätzlich noch ein drittes Strahlungsfeld 260 und ein viertes Strahlungsfeld 360 vorgesehen, welche ebenfalls quer zueinander und noch zusätzlich quer zu dem ersten Strahlungsfeld 60 und dem zweiten Strahlungsfeld 160 verlaufen, vorzugsweise in einem Winkel von größenordnungsmäßig 45° zu diesen, so daß, wie in Fig. 13 dargestellt, die Erzeugung des Umwandlungsbereichs U durch die Überlagerung von vier Strahlungsfeldern, nämlich dem ersten Strahlungsfeld 60, dem zweiten Strahlungsfeld 160, dem dritten Strahlungsfeld 260 und dem vierten Strahlungsfeld 360 erfolgt und nur in dem Bereich, in dem sich alle vier Strahlungsfelder 60, 160, 260, 360 überlappen, eine vollständige Umwandlung des Materials der lichtempfindlichen Schicht 34 von dem Ausgangszustand in den vollständig umgewandelten Zustand erfolgt. Damit läßt sich der Umwandlungsbereich U mit einer Außenkontur herstellen, welche in der jeweiligen Richtung durch die Breite B des entsprechenden Strahlungsfeldes der vier Strahlungsfelder bestimmt ist, wenn man davon ausgeht, daß nur die Wirkung der Überlagerung der Intensitäten von vier Strahlungsfeldern zu einem Umwandlungsbereich U führt.

Geht man davon aus, daß alle Strahlungsfelder 60, 160, 260, 360 dieselbe Breite B aufweisen, so ist der Durchmesser des Umwandlungsbereichs U durch die Breite B derselben definiert.

## Patentansprüche

1. Lithographieverfahren zum Herstellen von sich in einer Fläche erstreckenden Strukturen in einer lichtempfindlichen Schich (34) durch Belichten derselben mittels einer großen Zahl aufeinanderfolgender Belichtungsschritte zur Erzeugung einer Vielzahl von Umwandlungsbereichen (U) in der lichtempfindlichen Schicht, die zusammen die Strukturen ergeben, wobei jeder Belichtungsschritt dazu dient, mittels eines Strahlungsfeldes (60) innerhalb des Umwandlungsbereichs das die lichtempfindliche Schicht bildende Material von einem unbelichteten Ausgangszustand in den umgewandelten Endzustand zu überführen und wobei das Strahlungsfeld durch Fokussieren von Laserstrahlung und zusätzliches Begrenzen der Laserstrahlung in einer Breitenrichtung (BR) mittels einer senkrecht zur Breitenrichtung langgestreckten Blendenöffnung (58) in der lichtempfindlichen Schicht mit einer wirksamen Ausdehnung in der Breitenrichtung erzeugt wird, die in der Größenordnung der Wellenlänge der Laserstrahlung oder kleiner ist, **dadurch gekennzeichnet, dass** zur Herstellung eines Teils der Umwandlungsbereiche Strahlungsfelder mit einer Energieverteilung eingesetzt werden, die es erforderlich macht, dass mindestens die Einwirkung zweier Strahlungsfelder auf denselben Umwandlungsbereich in der lichtempfindlichen Schicht erforderlich ist, um in diesem das Material der lichtempfindlichen Schicht in den Endzustand zu überführen.

2. Verfahren nach Anspruch 1, **dadurch gekennzeichnet, dass** die mindestens zwei Strahlungsfelder überlappend auf die lichtempfindliche Schicht einwirken und dass ein Überlappungsbereich derselben den Umwandlungsbereich überdeckt.

3. Verfahren nach Anspruch 1 oder 2, **dadurch gekennzeichnet, dass** die überlappenden Strahlungsfelder mit ihren Breitenrichtungen parallel zueinander verlaufen.

4. Verfahren nach einem der voranstehenden Ansprüche, **dadurch gekennzeichnet, dass** ein erstes Strahlungsfeld der auf denselben Umwandlungsbereich wirkenden Strahlungsfelder die wirksame Ausdehnung in einer Breitenrichtung längs einer ersten Richtung aufweist und dass ein zweites Strahlungsfeld der auf denselben Umwandlungsbereich wirkenden Strahlungsfelder eine wirksame Ausdehnung in einer Breitenrichtung aufweist, die längs einer zweiten, im Winkel zur ersten Richtung verlaufenden Richtung verläuft.

5. Verfahren nach einem der voranstehenden Ansprüche, **dadurch gekennzeichnet, dass** die Strahlungsfelder so überlagert werden, dass die Überlagerung in dem Mittenbereich mindestens eines der Strahlungsfelder erfolgt.

6. Verfahren nach Anspruch 5, **dadurch gekennzeichnet, dass** die Strahlungsfelder (60, 160, 260, 360) so angeordnet werden, dass deren mittige Bereiche überlappen.

7. Verfahren nach einem der voranstehenden Ansprüche, **dadurch gekennzeichnet, dass** die Strahlungsfelder alle bezüglich eines ausgewählten Strahlungsfeldes in einem unterschiedlichen Winkel angeordnet werden.

8. Verfahren nach Anspruch 7, **dadurch gekennzeichnet, dass** die zu einem einzigen Umwandiungsbereich (U) beitragenden Strahlungsfelder (60, 160, 260, 360) ungefähr in gleichem Winkelabstand aufeinanderfolgend angeordnet werden.

9. Verfahren nach einem der voranstehenden Ansprüche, **dadurch gekennzeichnet, dass** die auf einen einzigen Umwandlungsbereich einwirkenden Strahlungsfelder zeitlich aufeinanderfolgend auf diesen Umwandlungsbereich einwirken.

10. Verfahren nach Anspruch 9, **dadurch gekennzeichnet, dass** die Strahlungsfelder zeitlich überlappend auf den Umwandlungsbereich einwirken.

11. Verfahren nach einem der voranstehenden Ansprüche, **dadurch gekennzeichnet, dass** die auf einen einzigen Umwandlungsbereich einwirkenden Strahlungsfelder im Wesentlichen gleichzeitig auf diesen Umwandlungsbereich einwirken.

12. Verfahren nach Anspruch 11, **dadurch gekennzeichnet, dass** zur Erzeugung Strahlungsfelder eine Blende (54) verwendet wird, die zwei schräg oder quer zueinander verlaufende und überlappend angeordnete Blendenöffnungen (58) aufweist und dass der Blende (54) Laserstrahlung in zwei der Ausrichtung der Blendenöffnungen (58) entsprechenden Polarisationsrichtungen zugeführt wird.

13. Verfahren nach einem der voranstehenden Ansprüche, **dadurch gekennzeichnet, dass** eine Vielzahl von Laserstrahlungsquellen (10) zur Erzeugung einer Vielzahl von Laserstrahlungen verwendet wird, mit welchen eine Vielzahl von Strahlungsfeldern (60, 160, 260, 360) erzeugt wird, die entsprechend der Form der Struktur (100) aktivierbar und deaktivierbar sind.

14. Verfahren nach Anspruch 13, **dadurch gekennzeichnet, dass** die Vielzahl von erzeugbaren Strahlungsfeldern (60, 160, 260, 360) ein erstes Strahlungsfeldmuster (70) aus definiert relativ zueinander angeordneten ersten erzeugbaren Strahlungsfeldern (60) aufweist, deren Breitenausdehnungen (B) parallel zu einer ersten Richtung (108) verlaufen.

15. Verfahren nach Anspruch 14, **dadurch gekennzeichnet, dass** das erste Strahlungsfeldmuster (70) von einem als Referenz dienenden ersten Strahlungsfeld (60₁) ausgehend in einer senkrecht zur Belichtungsbewegungsrichtung (104) verlaufenden Querrichtung (108) in unterschiedlichen Abständen angeordnete erste Strahlungsfelder (60₁ bis 60_{N}) aufweist, dass jedes erste Strahlungsfeld (60₁ bis 60_{N}) des ersten Strahlungsfeldmusters (70) in der Querrichtung (108) einen anderen Abstand (AQ) von dem als Referenz dienenden ersten Strahlungsfeld (60₁) aufweist als die übrigen ersten Strahlungsfelder (60₂ bis 60_{N}), dass die Abstände (AQ) aller ersten Strahlungsfelder (60₁ bis 60_{N}) des ersten Strahlungsfeldmusters (70) eine Serie von Abständen bilden, bei der jeder Abstand (AQ) um ein Inkrement (d) größer als ein anderer der Abstände ist, und dass das Inkrement (d) kleiner als eine Erstreckung (B) der ersten Strahlungsfelder (60₁ bis 60_{N}) in der Querrichtung (108) ist.

16. Verfahren nach einem der Ansprüche 13 bis 15, **dadurch gekennzeichnet, dass** die Vielzahl der erzeugbaren Strahlungsfelder (60, 160, 260, 360) ein zweites Strahlungsfeldmuster (170) aus definiert relativ zueinander angeordneten zweiten erzeugbaren Strahlungsfeldern (160) aufweist, deren Breitenausdehnungen (BR) parallel zu einer zweiten Richtung (104) verlaufen.

17. Verfahren nach Anspruch 16, **dadurch gekennzeichnet, dass** die zweite Richtung (104) in einem Winkel oder quer zur ersten Richtung (108) verläuft.

18. Verfahren nach Anspruch 16 oder 17, **dadurch gekennzeichnet, dass** das zweite Strahlungsfeldmuster (170) von einem als Referenz dienenden zweiten Strahlungsfeld (160₁) ausgehend in einer senkrecht zur Belichtungsbewegungsrichtung (104) verlaufenden Querrichtung (108) in unterschiedlichen Abständen angeordnete zweite Strahlungsfelder (160₁ bis 160_{N}) aufweist, dass jedes zweite Strahlungsfeld (160₁ bis 160_{N}) des zweiten Strahlungsfeldmusters (170) in der Querrichtung (108) einen anderen Abstand (AQ) von dem als Referenz dienenden zweiten Strahlungsfeld (160₁) aufweist als die übrigen zweiten Strahlungsfelder (160₂ bis 160_{N}), dass die Abstände (AQ) aller zweiten Strahlungsfelder (160₁ bis 160_{N}) des zweiten Strahlungsfeldmusters eine Serie von Abständen bilden, bei der jeder Abstand (AQ) um ein Inkrement (d) größer als ein anderer der Abstände ist und dass das Inkrement (d) kleiner als eine Erstreckung (L) der zweiten Strahlungsfelder (160₁ bis 160_{N}) in der Querrichtung (108) ist.

19. Verfahren nach einem der Ansprüche 15 bis 18, **dadurch gekennzeichnet, dass** das Inkrement (d) maximal die Hälfte der Erstreckung (B, L) der Strahlungsfelder (60, 160) in der Querrichtung (108) beträgt.

20. Verfahren nach einem der Ansprüche 14 bis 19, **dadurch gekennzeichnet, dass** das Strahlungsfeldmuster (70, 170) mindestens eine in einer Reihe angeordnete Serie (62) von Strahlungfeldern (60₁ bis 60_{N}, 160₁ bis 160_{N}) umfasst, die senkrecht zur Belichtungsbewegungsrichtung (104) einen Abstand (AQ) voneinander aufweisen, welcher kleiner als deren Ausdehnung (B, L) senkrecht zur Belichtungsbewegungsrichtung (104) ist.

21. Verfahren nach Anspruch 20, **dadurch gekennzeichnet, dass** der Abstand (AQ) zwischen den Strahlungsfeldern (60₁ bis 60_{N}, 160₁ bis 160_{N}) der Serie (62) senkrecht zur Belichturigsbewegungsrichtung (104) konstant ist.

22. Verfahren nach Anspruch 20 oder 21, **dadurch gekennzeichnet, dass** in der Serie (62) die Strahlungsfelder (60₁ bis 60_{N}, 160₁ bis 160_{N}) in einer längs einer Geraden (64) verlaufenden Reihe angeordnet sind.

23. Verfahren nach Anspruch 22, **dadurch gekennzeichnet, dass** in der jeweiligen Reihe die Strahlungsfelder (60₁ bis 60_{N}, 160₁ bis 160_{N}) in der Serienrichtung (64) einen Abstand (A) voneinander aufweisen, welcher größer ist als deren Erstreckung in der Serienrichtung (64).

24. Verfahren nach Anspruch 23, **dadurch gekennzeichnet, dass** die Serienrichtung (64) einen Winkel (α) von ungleich 90° mit der Belichtungsbewegungsrichtung (104) einschließt.

## Claims

1. Lithography method for the production of structures extending in a surface area in a light-sensitive layer (34) due to exposure thereof by means of a large number of successive exposure steps for generating a plurality of conversion areas (U) in the light-sensitive layer together resulting in the structures, wherein each exposure step serves to transfer the material forming the light-sensitive layer from an unexposed initial state into the converted end state within the conversion area by means of a radiation field (60) and wherein the radiation field is generated in the light-sensitive layer by the focusing of laser radiation and additional limitation of the laser radiation in a lateral direction (BR) by means of a screen aperture (58) elongated at right angles to the lateral direction with an effective extension in the lateral direction in the order of magnitude of the wavelength of the laser radiation or less, **characterized in that** for the production of some of the conversion areas radiation fields are used with a distribution of energy making it necessary for the action of at least two radiation fields on the same conversion area in the light-sensitive layer to be required in order to transfer the material of the light-sensitive layer in this area into the end state.

2. Method as defined in claim 1, **characterized in that** the at least two radiation fields act on the light-sensitive layer in an overlapping manner and that an overlapping area thereof covers the conversion area.

3. Method as defined in claim 1 or 2, **characterized in that** the overlapping radiation fields extend parallel to one another with their lateral directions.

4. Method as defined in any one of the preceding claims, **characterized in that** a first radiation field of the radiation fields acting on the same conversion area has the effective extension in a lateral direction along a first direction and that a second radiation field of the radiation fields acting on the same conversion area has an effective extension in a lateral direction extending along a second direction extending at an angle to the first direction.

5. Method as defined in any one of the preceding claims, **characterized in that** the radiation fields are superimposed such that the superposition is brought about in the central area of at least one of the radiation fields.

6. Method as defined in claim 5, **characterized in that** the radiation fields (60, 160, 260, 360) are arranged such that their central areas overlap.

7. Method as defined in any one of the preceding claims, **characterized in that** the radiation fields are all arranged at a different angle with respect to a selected radiation field.

8. Method as defined in claim 7, **characterized in that** the radiation fields (60, 160, 260, 360) contributing to a single conversion area (U) are arranged so as to follow one another approximately at the same angular distance.

9. Method as defined in any one of the preceding claims, **characterized in that** the radiation fields acting on a single conversion area act on this conversion area one after the other with respect to time.

10. Method as defined in claim 9, **characterized in that** the radiation fields act on the conversion area in a manner overlapping with respect to time.

11. Method as defined in any one of the preceding claims, **characterized in that** the radiation fields acting on a single conversion area act on this conversion area essentially simultaneously.

12. Method as defined in claim 11, **characterized in that** a screen (54) is used for generating radiation fields, said screen having two screen apertures (58) arranged so as to overlap and extending at an angle or transversely to one another and that the screen (54) is supplied with laser radiation in two directions of polarization corresponding to the alignment of the screen apertures (58).

13. Method as defined in any one of the preceding claims, **characterized in that** a plurality of laser radiation sources (10) is used for generating a plurality of laser radiations, a plurality of radiation fields (60, 160, 260, 360) being generated with said laser radiations and being activatable and deactivatable in accordance with the shape of the structure (100).

14. Method as defined in claim 13, **characterized in that** the plurality of generatable radiation fields (60, 160, 260, 360) has a first radiation field pattern (70) consisting of first generatable radiation fields (60) arranged in a defined manner relative to one another, the lateral extensions (B) of said radiation fields extending parallel to a first direction (108).

15. Method as defined in claim 14, **characterized in that** proceeding from a first radiation field (60₁) serving as reference the first radiation field pattern (70) has first radiation fields (60₁ to 60_{N}) arranged at different distances in a transverse direction (108) extending at right angles to the exposure movement direction (104), that each first radiation field (60₁ to 60_{N}) of the first radiation field pattern (70) has in the transverse direction (108) a different distance (AQ) from the first radiation field (60₁) serving as reference than the remaining first radiation fields (60₂ to 60_{N}), that the distances (AQ) of all the first radiation fields (60₁ to 60_{N}) of the first radiation field pattern (70) form a series of distances, wherein each distance (AQ) is greater by one increment (d) than another one of the distances, and that the increment (d) is smaller than an extension (B) of the first radiation fields (60₁ to 60_{N}) in the transverse direction (108).

16. Method as defined in any one of claims 13 to 15, **characterized in that** the plurality of generatable radiation fields (60, 160, 260, 360) has a second radiation field pattern (170) consisting of second generatable radiation fields (160) arranged in a defined manner relative to one another, the lateral extensions (BR) of said radiation fields extending parallel to a second direction (104).

17. Method as defined in claim 16, **characterized in that** the second direction (104) extends at an angle or transversely to the first direction (108).

18. Method as defined in claim 16 or 17, **characterized in that** proceeding from a second radiation field (160₁) serving as reference the second radiation field pattern (170) has second radiation fields (160₁ to 160_{N}) arranged at different distances in a transverse direction (108) extending at right angles to the exposure movement direction (104), that each second radiation field (160₁ to 160_{N}) of the second radiation field pattern (170) has in the transverse direction (108) a different distance (AQ) from the second radiation field (160₁) serving as reference than the remaining second radiation fields (160₂ to 160_{N}), that the distances (AQ) of all the second radiation fields (160₁ to 160_{N}) of the second radiation field pattern form a series of distances, wherein each distance (AQ) is greater by one increment (d) than another one of the distances and that the increment (d) is smaller than an extension (L) of the second radiation fields (160₁ to 160_{N}) in the transverse direction (108).

19. Method as defined in any one of claims 15 to 18, **characterized in that** the increment (d) is at the most half the extension (B, L) of the radiation fields (60, 160) in the transverse direction (108).

20. Method as defined in any one of claims 14 to 19, **characterized in that** the radiation field pattern (70, 170) comprises at least one series (62) of radiation fields (60₁ to 60_{N}, 160₁ to 160_{N}) arranged in a row, said radiation fields having at right angles to the exposure movement direction (104) a distance (AQ) from one another smaller than their extension (B, L) at right angles to the exposure movement direction (104).

21. Method as defined in claim 20, **characterized in that** the distance (AQ) between the radiation fields (60₁ to 60_{N}, 160₁ to 160_{N}) of the series (62) is constant at right angles to the exposure movement direction (104).

22. Method as defined in claim 20 or 21, **characterized in that** in the series (62) the radiation fields (60₁ to 60_{N}, 160₁ to 160_{N}) are arranged in a row extending along a straight line (64).

23. Method as defined in claim 22, **characterized in that** in the respective row the radiation fields (60₁ to 60_{N}, 160₁ to 160_{N}) have in the series direction (64) a distance (A) from one another greater than their extension in the series direction (64).

24. Method as defined in claim 23, **characterized in that** the series direction (64) forms an angle (α) of not equal to 90° with the exposure movement direction (104).

## Revendications

1. Procédé de lithographie pour la fabrication de structures s'étendant dans une surface dans une couche photosensible (34) par l'exposition de celle-ci au moyen de nombreuses étapes d'exposition successives pour la génération d'une pluralité de zones de transformation (U) dans la couche photosensible, qui produisent ensemble les structures, chaque étape d'exposition servant à transformer au moyen d'un champ de rayonnement (60) dans la zone de transformation, le matériau formant la couche photosensible d'un état initial non exposé à l'état final transformé et le champ de rayonnement étant généré par la focalisation du rayonnement laser et la limitation supplémentaire du rayonnement laser dans un sens de largeur (BR) au moyen d'une ouverture de diaphragme (58) étirée en longueur perpendiculairement au sens de la largeur dans la couche photosensible avec une extension active dans le sens de la largeur qui est dans l'ordre de grandeur de la longueur d'onde du rayonnement laser ou plus petite, **caractérisé en ce que** pour la fabrication d'une partie des zones de transformation, des champs de rayonnement avec une distribution d'énergie sont utilisés, laquelle nécessite qu'au moins l'action de deux champs de rayonnement sur la même zone de transformation dans la couche photosensible soit nécessaire afin de transformer dans celle-ci le matériau de la couche photosensible à l'état final.

2. Procédé selon la revendication 1, **caractérisé en ce que** les aux moins deux champs de rayonnement agissent en chevauchant la couche photosensible et **en ce qu'**une zone de chevauchement de celle-ci recouvre la zone de transformation.

3. Procédé selon la revendication 1 ou 2, **caractérisé en ce que** les largeurs des champs de rayonnement chevauchants s'étendent parallèlement l'une à l'autre.

4. Procédé selon l'une quelconque des revendications précédentes, **caractérisé en ce qu'**un premier champ de rayonnement des champs de rayonnement agissant sur la même zone de transformation présente l'extension active dans un sens de largeur le long d'un premier sens et **en ce qu'**un second champ de rayonnement des champs de rayonnement agissant sur la même zone de transformation présente une extension active dans un sens de largeur qui s'étend le long d'un second sens s'étendant en angle par rapport au premier sens.

5. Procédé selon l'une quelconque des revendications précédentes, **caractérisé en ce que** les champs de rayonnement sont superposés de sorte que la superposition soit effectuée dans la zone médiane au moins d'un des champs de rayonnement.

6. Procédé selon la revendication 5, **caractérisé en ce que** les champs de rayonnement (60, 160, 260, 360) sont disposés de sorte que leurs zones médianes se chevauchent.

7. Procédé selon l'une quelconque des revendications précédentes, **caractérisé en ce que** les champs de rayonnement sont tous disposés par rapport à un champ de rayonnement sélectionné dans un angle différent.

8. Procédé selon la revendication 7, **caractérisé en ce que** les champs de rayonnement (60, 160, 260, 360) contribuant à une seule zone de transformation (U) sont disposés de manière successive à peu près à la même distance angulaire.

9. Procédé selon l'une quelconque des revendications précédentes, **caractérisé en ce que** les champs de rayonnement agissant sur une seule zone de transformation agissent chronologiquement de manière successive sur cette zone de transformation.

10. Procédé selon la revendication 9, **caractérisé en ce que** les champs de rayonnement agissent en se chevauchant chronologiquement sur la zone de transformation.

11. Procédé selon l'une quelconque des revendications précédentes, **caractérisé en ce que** les champs de rayonnement agissant sur une seule zone de transformation agissent essentiellement en même temps sur cette zone de transformation.

12. Procédé selon la revendication 11, **caractérisé en ce que** pour la génération des champs de rayonnement, un diaphragme (54) est utilisé, lequel présente deux ouvertures de diaphragme (58) s'étendant en biais ou transversalement l'une à l'autre et disposées se chevauchant et **en ce qu'**au diaphragme (54) est amené un rayonnement laser dans deux sens de polarisation correspondant à l'alignement des ouvertures de diaphragme (58).

13. Procédé selon l'une quelconque des revendications précédentes, **caractérisé en ce qu'**une pluralité de sources de rayonnement laser (10) est utilisée pour la génération d'une pluralité de rayonnements laser, avec lesquelles une pluralité de champs de rayonnement (60, 160, 260, 360) est générée, lesquels peuvent être activés et désactivés selon la forme de la structure (100).

14. Procédé selon la revendication 13, **caractérisé en ce que** la pluralité de champs de rayonnement (60, 160, 260, 360) pouvant être générés présente un premier modèle de champs de rayonnement (70) composé de premiers champs de rayonnement (60) pouvant être générés, disposés de manière définie relativement les uns par rapport aux autres, dont les élargissements (B) s'étendent parallèlement à un premier sens (108).

15. Procédé selon la revendication 14, **caractérisé en ce que** le premier modèle de champs de rayonnement (70) en partant d'un premier champ de rayonnement servant de référence présente des premiers champs de rayonnement (60₁ à 60_{N}) disposés à différentes distances dans un sens transversal (108) s'étendant perpendiculairement au sens de déplacement d'exposition (104), **en ce que** chaque premier champ de rayonnement (60₁ à 60_{N}) du premier modèle de champs de rayonnement (70) présente dans le sens transversal (108) une autre distance (AQ) du premier champ de rayonnement (60₁) servant de référence que les autres premiers champs de rayonnement (60₂ à 60_{N}), **en ce que** les distances (AQ) de tous les premiers champs de rayonnement (60₁ à 60_{N}) du premier modèle de champs de rayonnement (70) forment une série de distances, pour laquelle chaque distance (AQ) est supérieure d'un incrément (d) à une autre des distances, et **en ce que** l'incrément (d) est inférieur à une extension (B) des premiers champs de rayonnement (60₁ à 60_{N}) dans le sens transversal (108).

16. Procédé selon l'une quelconque des revendications 13 à 15, **caractérisé en ce que** la pluralité de champs de rayonnement (60, 160, 260, 360) pouvant être générés présente un second modèle de champs de rayonnement (170) composé de seconds champs de rayonnement (160) pouvant être générés, disposés de manière définie relativement les uns par rapport aux autres, dont les élargissements (BR) s'étendent parallèlement à un second sens.

17. Procédé selon la revendication 16, **caractérisé en ce que** le second sens (104) s'étend dans un angle ou transversalement au premier sens (108).

18. Procédé selon la revendication 16 ou 17, **caractérisé en ce que** le second modèle de champs de rayonnement (170) en partant d'un second champ de rayonnement (160₁) servant de référence présente des seconds champs de rayonnement (160₁ à 160_{N}) disposés à différentes distances dans un sens transversal (108) s'étendant perpendiculairement au sens de déplacement d'exposition (104), **en ce que** chaque second champ de rayonnement (160₁ à 160_{N}) du second modèle de champs de rayonnement (170) présente dans le sens transversal (108) une autre distance (AQ) du second champ de rayonnement (160₁) servant de référence que les autres seconds champs de rayonnement (160₂ à 160_{N}), **en ce que** les distances (AQ) de tous les seconds champs de rayonnement (160₁ à 160_{N}) du second modèle de champs de rayonnement forment une série de distances, pour laquelle chaque distance (AQ) est supérieure d'un incrément (d) à une autre des distances et **en ce que** l'incrément (d) est inférieur à une extension (L) des seconds champs de rayonnement (160₁ à 160_{N}) dans le sens transversal (108).

19. Procédé selon l'une quelconque des revendications 15 à 18, **caractérisé en ce que** l'incrément (d) s'élève au maximum à la moitié de l'extension (B, L) des champs de rayonnement (60, 160) dans le sens transversal (108).

20. Procédé selon l'une quelconque des revendications 14 à 19, **caractérisé en ce que** le modèle de champs de rayonnement (70, 170) comprend au moins une série (62) disposée en rangée de champs de rayonnement (60₁ à 60_{N}, 160₁ à 160_{N}), qui présentent perpendiculairement au sens de déplacement d'exposition (104) une distance (AQ) les uns des autres, qui est plus petite que leur extension (B, L) perpendiculairement au sens de déplacement d'exposition (104).

21. Procédé selon la revendication 20, **caractérisé en ce que** la distance (AQ) entre les champs de rayonnement (60₁ à 60_{N}, 160₁ à 160_{N}) de la série (62) est constante perpendiculairement au sens de déplacement d'exposition (104).

22. Procédé selon la revendication 20 ou 21, **caractérisé en ce que** dans la série (62), les champs de rayonnement (60₁ à 60_{N}, 160₁ à 160_{N}) sont disposés dans une rangée s'étendant le long d'une droite (64).

23. Procédé selon la revendication 22, **caractérisé en ce que** dans la rangée respective, les champs de rayonnement (60₁ à 60_{N}, 160₁ à 160_{N}) présentent dans le sens de la série (64) une distance (A) les uns des autres qui est supérieure à leur extension dans le sens de la série (64).

24. Procédé selon la revendication 23, **caractérisé en ce que** le sens de la série (64) forme un angle (α) inégal à 90° avec le sens de déplacement d'exposition (104).
